(19) Europäisches Patentamt
European Patent Office
Office européen des brevets

(11) **EP 4 675 299 A1**

(12) **EUROPEAN PATENT APPLICATION**
published in accordance with Art. 153(4) EPC

(43) Date of publication:
**07.01.2026 Bulletin 2026/02**

(21) Application number: **24764017.0**

(22) Date of filing: **29.02.2024**

(51) International Patent Classification (IPC):
**G01R 33/12** (2006.01)    **G01N 27/72** (2006.01)
**G01R 33/032** (2006.01)

(52) Cooperative Patent Classification (CPC):
**G01N 27/72; G01R 33/032; G01R 33/12**

(86) International application number:
**PCT/JP2024/007577**

(87) International publication number:
**WO 2024/181540 (06.09.2024 Gazette 2024/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **02.03.2023 JP 2023032148**

(71) Applicant: **NIPPON STEEL CORPORATION**
**Chiyoda-ku**
**Tokyo 100-8071 (JP)**

(72) Inventors:
• **HONMA, Rei**
  **Tokyo 100-8071 (JP)**
• **KAWAMURA, Yusuke**
  **Tokyo 100-8071 (JP)**

(74) Representative: **Vossius & Partner**
**Patentanwälte Rechtsanwälte mbB**
**Siebertstrasse 3**
**81675 München (DE)**

(54) **PROCESSING SYSTEM, SOFT MAGNETIC MATERIAL, SOFT MAGNETIC INTERMEDIATE MATERIAL, TRANSFORMER, PROCESSING METHOD, AND PROGRAM**

(57)    A processing device (200) derives, based on the result of comparison of a region to be compared with a template image (410), magnetic domain information at a pixel to be compared (520) in the region to be compared (510).

F I G. 1

EP 4 675 299 A1

**Description**

TECHNICAL FIELD

The present disclosure relates to a processing system, a soft magnetic material, a soft magnetic intermediate material, a transformer, a processing method, and a program. This application is based upon and claims the benefit of priority of the prior Japanese Patent Application No. 2023-032148, filed on March 2, 2023, the entire contents of which are incorporated herein by reference.

BACKGROUND ART

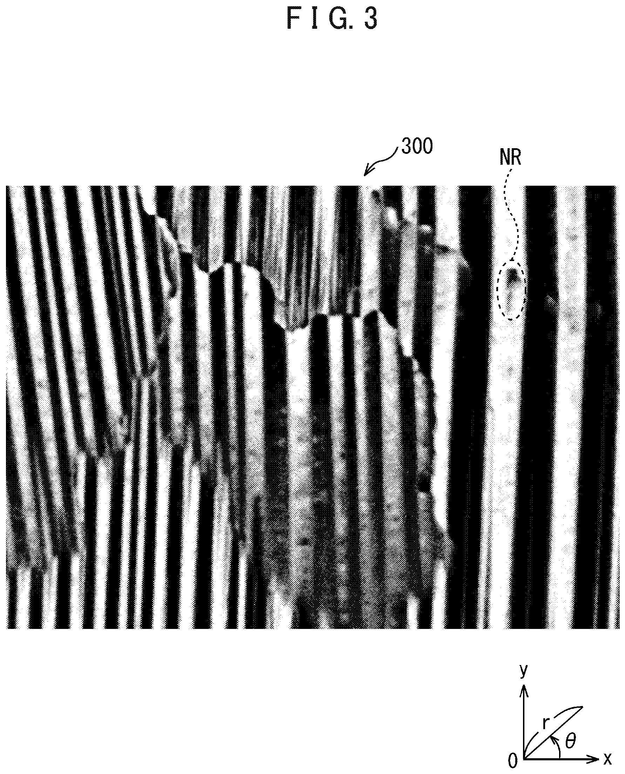

Conventionally, magnetic domain information in magnetic bodies such as grain-oriented electrical steel sheets and non-oriented electrical steel sheets has been important in evaluating the magnetic bodies, as it is used to estimate the properties of the magnetic bodies. The magnetic domain information is information that represents the characteristics of magnetic domains. The magnetic domain information includes, for example, at least one of the width of the magnetic domain and the direction in which the magnetic domain extends (in the following explanation, the width of the magnetic domain is referred to as a magnetic domain width as necessary, and the direction in which the magnetic domain extends is referred to as a magnetic domain direction as necessary). For example, the magnetic domain width is a factor that greatly affects an abnormal eddy current loss of a magnetic body. The iron loss of the magnetic body can be estimated from the distribution of magnetic domain widths in the magnetic body. Such magnetic domain information can also be obtained from an analysis of magnetic domain images (see Patent. Literature 1). The magnetic domain image is an image obtained by converting measurement results of the orientation of a magnetic moment at each position in the magnetic body to be evaluated into pixel values and visualizing them. This magnetic domain image is usually a striped pattern image. In the magnetic domain image, there are sometimes the following cases where the width of a stripe varies depending on the position within the magnetic domain image, stripes are changed in width irregularly within the magnetic domain image, and noise such as an unclear portion is contained in the magnetic domain image (see Fig. 3 to be described later). It is not easy to obtain magnetic domain information at such positions within the magnetic domain image. Therefore, there is a demand for a technique to obtain magnetic domain information from a magnetic domain image without being affected by these factors as much as possible.

Patent Literature 1 has disclosed the following. First, from a magnetic domain image, a plurality of partial regions (rectangular regions) corresponding to positions different mutually in the magnetic domain image are cut out. A two-dimensional Fourier transform is then performed on each of the partial regions cut out from the magnetic domain image in this manner, thereby calculating a spatial frequency component of each of the partial regions. Then, the magnetic domain width and the magnetic domain direction are calculated based on the spatial frequency components.

CITATION LIST

PATENT LITERATURE

Patent Literature 1: Japanese Laid-open Patent Publication No. 2021-169979

SUMMARY OF INVENTION

TECHNICAL PROBLEM

However, in the technique described in Patent Literature 1, the Fourier transform is performed, and thus the accuracy of the magnetic domain information is limited by the resolution resulting from Nyquist sampling theorem. Further, in the technique described in Patent Literature 1, if the pixel value varies periodically in the magnetic domain image, there is a possibility that the position that is not a magnetic domain may be recognized as a magnetic domain. Specifically, the width of a stripe that is present locally due to noise or other reasons may also be calculated as the magnetic domain width (regarding the stripe that is present locally due to noise or other reasons, see also a later-described region NR in Fig. 6). Therefore, the technique described in Patent Literature 1 may be significantly affected by the factors described previously. Therefore, the technique described in Patent Literature 1 has a problem that there is a risk of failing to obtain accurate information as the magnetic domain information.

The present disclosure has been made in consideration of the above problems, and an object thereof is to derive magnetic domain information from a magnetic domain image with higher accuracy.

SOLUTION TO PROBLEM

The processing system of the present disclosure is a processing system that derives magnetic domain information on a magnetic domain image to be processed, the processing system including: a comparison part that compares a region to be compared in the magnetic domain image to be processed with one or more template images being an image having the magnetic domain information; and a magnetic domain information deriving part that derives the magnetic domain information in the region to be compared based on a result of the comparison, in which there are a plurality of the template images that are able to be compared with the region to be compared by the comparison part, and a plurality of the template images have pieces of the magnetic domain information that are different mutually.

Further, the processing system of the present disclosure may further include a processing part that performs processing based on magnetic domain information derived by the magnetic domain information deriving part.

In this case, the magnetic domain information may include magnetic domain widths. Further, the processing part may derive information representing a frequency distribution of the magnetic domain widths derived with one of the magnetic domain images or a plurality of the magnetic domain images set as the magnetic domain image to be processed. Further, the processing part may perform processing for adjusting the magnetic domain width of a soft magnetic material based on the information representing the frequency distribution of the magnetic domain widths. Further, the processing part may perform processing for adjusting the magnetic domain width of the soft magnetic material based on a representative value of the magnetic domain widths in the information representing the frequency distribution of the magnetic domain widths. The representative value may be a mode value.

The soft magnetic material of the present disclosure, in which in information representing a frequency distribution of the magnetic domain widths derived by the processing part included in the processing system, a mode value of the magnetic domain width is 200 $\mu$m or more and less than 400 $\mu$m.

The soft magnetic intermediate material of the present disclosure is a soft magnetic intermediate material for manufacturing the soft magnetic material, in which in information representing a frequency distribution of the magnetic domain widths derived by the processing part included in the processing system, a mode value of the magnetic domain width is 700 $\mu$m or more.

The transformer of the present invention includes a core including the soft magnetic material.

The processing method of the present disclosure is a processing method of deriving magnetic domain information on a magnetic domain image to be processed, the method including: a comparison step of comparing a region to be compared in the magnetic domain image to be processed with one or more template images being an image having the magnetic domain information; and a magnetic domain information deriving step of deriving the magnetic domain information in the region to be compared based on a result of the comparison, in which there are a plurality of the template images that are able to be compared with the region to be compared in the comparison step, and a plurality of the template images have pieces of the magnetic domain information that are different mutually.

The program of the present disclosure causes a computer to function as each part of the processing system.

BRIEF DESCRIPTION OF DRAWINGS

[Fig. 1] Fig. 1 is a view illustrating a first example of a configuration of a processing system.
[Fig. 2A] Fig. 2A is a diagram illustrating an example of a configuration of hardware of a processing device.
[Fig. 2B] Fig. 2B is a diagram illustrating a first example of a functional configuration of the processing device.
[Fig. 3] Fig. 3 is a view illustrating an example of a magnetic domain image.
[Fig. 4] Fig. 4 is a view illustrating a first example of a template image group.
[Fig. 5] Fig. 5 is a view conceptually illustrating an example of a method of comparing a region to be compared with a template image.
[Fig. 6] Fig. 6 is a view explaining why it is difficult for a region that is not a magnetic domain to be detected as a magnetic domain.
[Fig. 7A] Fig. 7A is a flowchart explaining a first example of a processing method.
[Fig. 7B] Fig. 7B is a flowchart continuing from Fig. 7A.
[Fig. 8] Fig. 8 is a view illustrating a second example of the template image group.
[Fig. 9] Fig. 9 is a diagram illustrating a second example of the functional configuration of the processing device.
[Fig. 10A] Fig. 10A is a view illustrating an example of a histogram of magnetic domain widths.
[Fig. 10B] Fig. 10B is a view illustrating an example of a function of a frequency distribution of the magnetic domain widths.
[Fig. 11] Fig. 11 is a flowchart explaining a second example of the processing method.
[Fig. 12A] Fig. 12A is a view illustrating a magnetic domain image used in this calculation example.

[Fig. 12B] Fig. 12B is a view illustrating a calculation result of a magnetic domain width in this calculation example.

DESCRIPTION OF EMBODIMENTS

Hereinafter, there will be explained embodiments of the present disclosure with reference to the drawings.

Incidentally, in the following explanation, the fact that objects to be compared such as lengths, positions, sizes, and intervals, are the same includes the case where they are strictly the same, as well as the case where they are different within a range that does not depart from the gist of the present disclosure (for example, the case where they are different within a tolerance range defined at the time of design).

(First embodiment)

First, a first embodiment is explained.

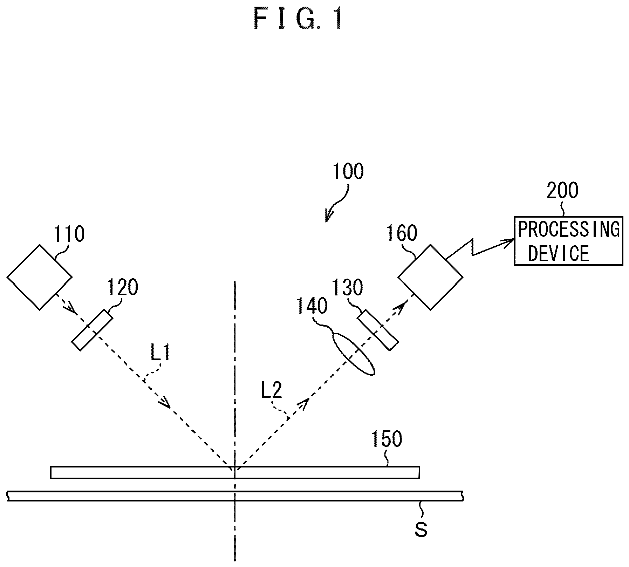

Fig. 1 is a view illustrating an example of a configuration of a processing system. In Fig. 1, the processing system in this embodiment creates a magnetic domain image of a magnetic body S, and derives magnetic domain information on a portion of the magnetic body S that corresponds to this magnetic domain image based on the magnetic domain image. The magnetic domain information is information that represents characteristics of a magnetic domain. The magnetic domain information includes, for example, at least one of the following information: the magnetic domain width and the magnetic domain direction. This embodiment explains, as an example, the case where the magnetic domain information is quantitative information (numerical value information). However, the magnetic domain information may be qualitative information (non-numerical value information (for example, information indicating the degree, which is long, short, or the like)). Further, the magnetic domain information may be information that can be determined at one time.

Fig. 1 illustrates, as an example, the case where the processing system includes a magnetic domain image acquisition device 100 and a processing device 200 in this embodiment.

<Magnetic domain image acquisition device 100>

The magnetic domain image acquisition device 100 is a device that acquires a magnetic domain image of the magnetic body S. In the magnetic domain image, the orientation of a magnetic moment to be measured at each position in a measurement target region of the magnetic body S is converted into a value corresponding to the orientation. The value of each pixel (pixel value) of the magnetic domain image is represented by a value corresponding to the orientation of the magnetic moment measured at the position corresponding to the pixel. As the pixel value of each pixel included in the magnetic domain image, either two or more values (gradation values) in which orientations of magnetic moments different mutually can be distinguished, or two or more values (gradation values) in which the degree of difference between orientations of magnetic moments different mutually can be distinguished are taken. Fig. 1 illustrates, as an example, the case where the magnetic domain image acquisition device 100 includes a light source 110, a polarizer 120, an analyzer 130, an optical system 140, a magneto-optical element 150, and a camera 160.

The light source 110 includes, for example, a light emitting diode and outputs light.

The polarizer 120 has light with a uniform polarization plane (linearly polarized light L1) from the light output from the light source 110 pass therethrough. The linearly polarized light L1 is applied to the magneto-optical element 150.

The magneto-optical element 150 is an element (sensor) that utilizes the Faraday effect to detect the structure of the magnetic body S. The magneto-optical element 150 includes, for example, a transparent substrate, a magneto-optical film, and a reflective film. The magneto-optical film and the reflective film are stacked in this order on the transparent substrate. Incidentally, the magneto-optical element is also referred to as an MO sensor or the like.

The magnetic body S is arranged on the reflective film side of the magneto-optical element 150. A leakage magnetic field corresponding to the orientation of the magnetic moment inside the magnetic body S is generated from the magnetic body S. This leakage magnetic field is applied to the magneto-optical film of the magneto-optical element 150. The polarization plane of the linearly polarized light L1 that has entered the inside of the magneto-optical element 150 from the transparent substrate side undergoes Faraday rotation in the magneto-optical film at an angle corresponding to the magnitude of the leakage magnetic field from the magnetic body S (this angle is referred to as a Faraday rotation angle). The light whose polarization plane has rotated is reflected by the reflective film. The polarization plane of the light reflected by the reflective film undergoes Faraday rotation again in the magneto-optical film. In this manner, reflected light L2 whose polarization plane has rotated according to the magnitude of the leakage magnetic field from the magnetic body S is emitted from the magneto-optical element 150 toward the camera 160.

The polarizer 120 and the analyzer 130 are arranged to be brought into a state where their transmission axes are perpendicular to each other (crossed Nicols). An image of the reflected light L2 is formed by the optical system 140 including an imaging lens or the like, and then the reflected light L2 enters the analyzer 130. Of the light that has entered the analyzer 130, light with an intensity corresponding to the Faraday rotation angle of the polarization plane of the reflected light L2 passes through the analyzer 130 and enters the camera 160.

The camera 160 includes, for example, an image sensor and an image processing circuit. In this embodiment, the light with an intensity corresponding to the orientation of the leakage magnetic field from the magnetic body S enters a light-receiving element of the image sensor. The image sensor converts the light that has entered the light-receiving element into an electrical signal. The image processing circuit performs well-known image processing for generating an image signal on the electrical signal corresponding to the light that has entered each light-receiving element of the image sensor, thereby creating a magnetic domain image having pixel values corresponding to orientations of magnetic moments of the magnetic body S.

The image sensor may include a CMOS (Complementary Metal-Oxide-Semiconductor) image sensor, a CCD (Charge Coupled Device) image sensor, or other image sensors. Incidentally, this embodiment explains, as an example, the case where the magnetic domain image is a two-dimensional image. Therefore, it is preferable that the image sensor included in the camera 160 should be an area sensor in which a plurality of light-receiving elements are arranged in a two-dimensional matrix. However, this embodiment does not necessarily need to be designed in this manner. For example, the image sensor included in the camera 160 may be a linear sensor in which a plurality of light-receiving elements are arranged linearly. When the image sensor included in the camera 160 is a linear sensor, a two-dimensional magnetic domain image may be obtained, for example, by scanning the linear sensor in a direction vertical to the direction in which the plural light-receiving elements are arranged.

The magnetic domain image of the magnetic body (soft magnetic material) being a target for acquiring magnetic domain images is photographed after the magnetic body is demagnetized. This embodiment explains, as an example, the case where, during demagnetization, the magnetic flux density in the magnetic body decays according to (1) Equation below. In this case, the magnetic body is demagnetized for 30 seconds. Therefore, this embodiment explains, as an example, the case where the magnetic domain image acquisition device 100 photographs (acquires) a magnetic domain image at a timing at which 30 seconds have passed since the magnetic flux density started to decay according to (1) Equation below. In this embodiment, unless otherwise specified, the magnetic domain image is photographed at such a timing.

$$B = 1.9e^{-0.2t} \cos 0.75\pi t \ \ldots \ (1)$$

Here, B is a magnetic flux density (T) and t is a time (sec).

Incidentally, the magnetic domain image acquisition device 100 can be fabricated by well-known techniques described in Patent Literature 1, and the like. Therefore, the magnetic domain image acquisition device 100 is not limited to the one having the configuration illustrated in Fig. 1. Further, as long as a magnetic domain image having a pixel value corresponding to the orientation of a magnetic moment at each measurement position in a measurement target region such as the magnetic body S can be obtained, it is not always necessary to obtain the magnetic domain image according to the principle explained with reference to Fig. 1.

<Processing device 200>

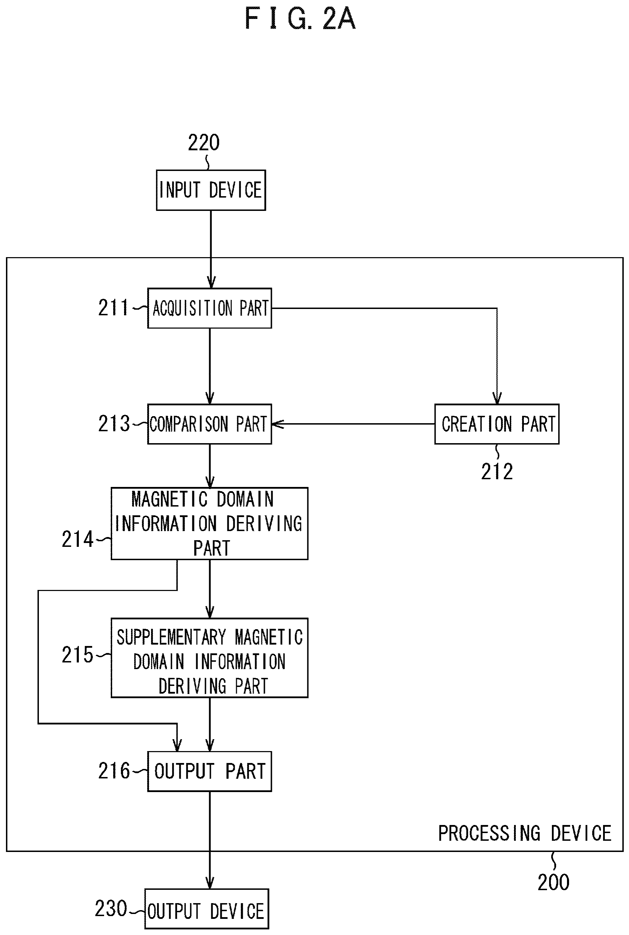

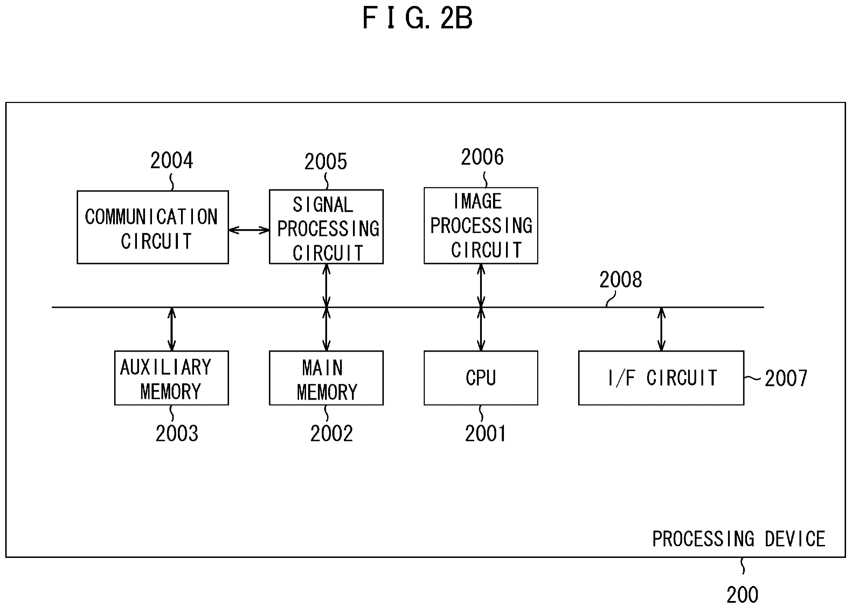

The processing device 200 performs processing including deriving magnetic domain information in a portion or all of the magnetic body S based on the magnetic domain image acquired by the magnetic domain image acquisition device 100. The magnetic body S is, for example, soft magnetic bodies such as grain-oriented electrical steel sheets and non-oriented electrical steel sheets. The shape of the magnetic body S may be plate-shaped, or does not need to be plate-shaped. Fig. 2Fig. 2A is a diagram illustrating an example of a functional configuration of the processing device 200.

The processing device 200 includes, as its hardware, one or more hardware processors, such as a CPU (Central Processing Unit), and one or more memories, such as a RAM (Random Access Memory) and a ROM (Read Only Memory), for example. The processing device 200 executes various arithmetic operations, for example, by executing one or more programs stored in the memory using one or more hardware processors.

Further, an input device 220 and an output device 230 are connected to the processing device 200 so as to be able to communicate with the processing device 200. The communication between the processing device 200 and the input device 220 and the output device 230 may be wire communication or radio communication. Further, the processing device 200 may also include the input device 220 and the output device 230.

Further, the processing device 200 may be fabricated by dedicated hardware such as an ASIC (Application Specific Integrated Circuit).

The hardware of the processing device 200 may be fabricated as illustrated in Fig. 2A, for example. In Fig. 2A, the processing device 200 includes a CPU 2001, a main memory 2002, an auxiliary memory 2003, a communication circuit 2004, a signal processing circuit 2005, an image processing circuit 2006, an I/F circuit 2007, and a bus 2008.

The CPU 2001 overall controls the entire processing device 200. The CPU 2001 uses the main memory 2002 as a work area to execute a program stored in the auxiliary memory 2003. The main memory 2002 stores data temporarily. The auxiliary memory 2003 stores various data, in addition to programs to be executed by the CPU 2001.

The communication circuit 2004 is a circuit intended for performing communication with the outside of the processing device 200. The communication circuit 2004 may perform radio communication, may perform wire communication, or may perform communication via a network with the outside of the processing device 200.

The signal processing circuit 2005 performs various pieces of signal processing on signals received in the communication circuit 2004 and signals input according to the control by the CPU 2001.

The image processing circuit 2006 performs various pieces of image processing on signals input according to the control by the CPU 2001. The signal that has been subjected to the image processing is output on the output device 230 (display), for example.

The I/F circuit 2007 exchanges data with a device connected to the I/F circuit 2007. As the device to be connected to the I/F circuit 2007, there is at least one of the input device 220 and the output device 230 illustrated in Fig. 2A, for example. However, the device to be connected to the I/F circuit 2007 is not limited to these devices.

Incidentally, the CPU 2001, the main memory 2002, the auxiliary memory 2003, the signal processing circuit 2005, the image processing circuit 2006, and the I/F circuit 2007 are connected to the bus 2008. The communication among these components is performed via the bus 2008. Further, the hardware of the processing device 110 is not limited to the hardware illustrated in Fig. 2A as long as it can perform the functions of the processing device 200. For example, a GPU may be used as a processor instead of or in addition to the CPU 2001.

Next, there is explained an example of a functional configuration of the processing device 200.

<<Acquisition part 211>>

An acquisition part 211 acquires a magnetic domain image to be processed and pre-acquired information. The pre-acquired information is information that needs to be acquired in advance in order for the processing device 200 to derive magnetic domain information on the magnetic body S. This embodiment explains, as an example, the case where template setting information and threshold value information are included in the pre-acquired information.

This embodiment explains, as an example, the case where the acquisition part 211 acquires the magnetic domain image created by the camera 160 from the input device 220. Further, this embodiment explains, as an example, the case where the camera 160 and the input device 220 perform wire communication via a communication cable.

In this case, the input device 220 includes a receiver. This embodiment explains, as an example, the case where the acquisition part 211 acquires the magnetic domain image received by the input device 220. However, the acquisition part 211 does not necessarily need to acquire the magnetic domain image in this manner. For example, the acquisition part 211 may acquire the magnetic domain image by the camera 160 and the input device 220 performing radio communication using a radio communication device included in the camera 160 or a not-illustrated radio communication device connected to the camera 160. Further, the processing device 200 may also have at least some of the functions of the camera 160. In this case, the acquisition part 211 may acquire the magnetic domain image by creating it as described previously.

Fig. 3 is a view illustrating an example of a magnetic domain image 300. Fig. 3 illustrates, as an example, the magnetic domain image 300 of the magnetic body S that is a grain-oriented electrical steel sheet. In the following explanation, the horizontal direction of the magnetic domain information 300 is the x-axis direction and the vertical direction of that is the y-axis direction. Incidentally, for convenience of notation, in Fig. 3, coordinates are illustrated at a position away from the magnetic domain image 300. However, this embodiment explains, as an example, the case where the origin of the coordinate system is located at a lower left corner of the magnetic domain image 300. Further, each drawing, including Fig. 3, illustrates both an x-y two-dimensional orthogonal coordinate system and a polar coordinate system (circular coordinates). Incidentally, the origin of the coordinate system is set at the position of the lower left corner of the image, which is true for each image other than the magnetic domain image 300 (template images 410, 810 and a region to be compared 510, which will be explained later).

Further, this embodiment explains, as an example, the case where the magnetic domain image 300 is a grayscale image (an image having gradation values of 0 to 255 as a pixel value in the case of an 8-bit image, for example). However, the magnetic domain image 300 is not limited to the grayscale image. For example, the magnetic domain image 300 may be a color image or a binary image.

The magnetic body S illustrated in the magnetic domain image 300 in Fig. 3 has a plurality of magnetic domains. This embodiment explains, as an example, the case where the plural magnetic domains are aligned approximately in the x-axis direction. Further, this embodiment explains, as an example, the case where the orientations of magnetic moments of the plural magnetic domains are approximately in the y-axis direction. Further, this embodiment explains, as an example, the case where the magnetic moments of the plural magnetic domains are alternately oriented in opposite directions along the x-axis direction. That is, in the magnetic domain image 300 in Fig. 3, each of the plural regions with relatively high gradation values (low-density white regions in Fig. 3) and each of the plural regions with relatively low gradation values (high-density black regions in Fig. 3) are magnetic domains.

Further, Fig. 3 illustrates, as an example, the case where each magnetic domain extends approximately in the y-axis direction. Further, Fig. 3 illustrates, as an example, the case where magnetic domains represented in white and magnetic domains represented in black are arranged alternately approximately along the x-axis direction. In this case, the boundary between these regions (the region where the density is reversed) indicates a 180° magnetic domain wall. However, due to factors such that there are magnetic domains whose orientations of magnetic moments are not parallel to the y-axis or noise is contained in the magnetic domain image 300, as illustrated in Fig. 3, the following can occur, in which the pixel values of the magnetic domain image 300 exhibit gradation values other than the minimum gradation value and the maximum gradation value, or the magnetic domain direction in the magnetic domain image 300 is not a specific direction (for example, a direction parallel to the y-axis). Further, as illustrated in the region NR in Fig. 3 as an example, the case can occur where when viewed locally, a region that looks like a magnetic domain is present in the magnetic domain image 300. Incidentally, in the magnetic domain image, 90° magnetic domains may also be included in addition to or instead of the 180° magnetic domains.

Returning to the explanation of Fig. 2B, as described previously, this embodiment explains, as an example, the case where the acquisition part 211 acquires the template setting information in addition to the magnetic domain image 300. As will be explained later in the section <<Comparison part 213>>, this embodiment illustrates, as an example, the case where the processing device 200 compares the region to be compared of the magnetic domain image 300 with each of a plurality of template images. The template setting information is information necessary for creating a plurality of template images. Incidentally, the timing at which the acquisition part 211 acquires the template setting information is not limited. The acquisition part 211 may acquire the template setting information in advance before acquiring the magnetic domain image 300, or may acquire the template setting information after acquiring the magnetic domain image 300.

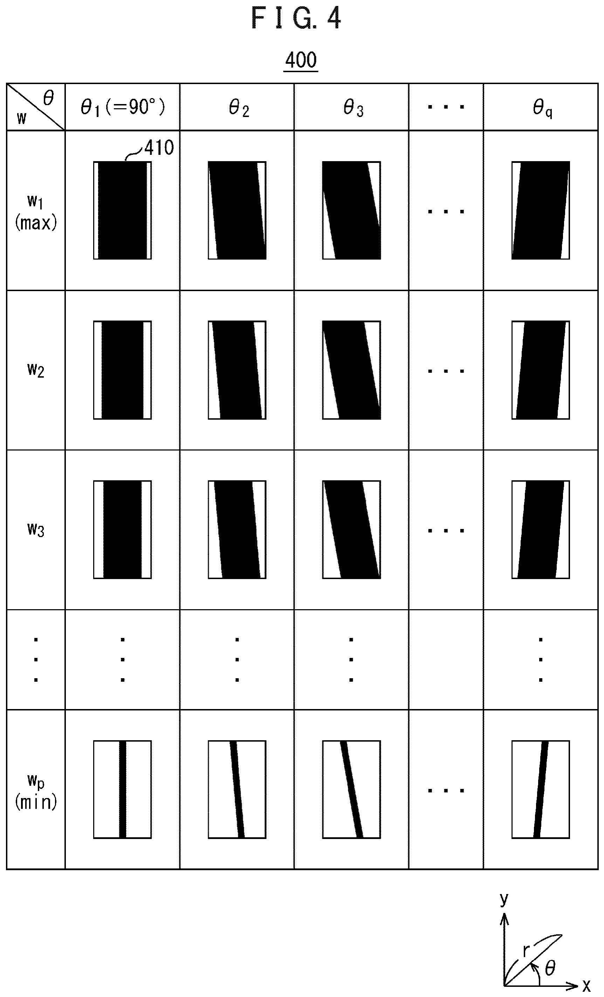

Fig. 4 is a view illustrating an example of a template image group 400 including the plural template images 410. Incidentally, in Fig. 4, for convenience of notation, only one template image is marked with a reference numeral (410). In the following explanation, the magnetic domain corresponding to the region with a low gradation value (high-density region in Fig. 3) is referred to as a first magnetic domain as necessary. Further, in the following explanation, the magnetic domain corresponding to the region with a high gradation value (low-density region in Fig. 3) is referred to as a second magnetic domain as necessary. Incidentally, the first magnetic domain and the second magnetic domain do not need to be defined as such magnetic domains as long as they are magnetic domains whose orientations of magnetic moments are different mutually. For example, the magnetic domain corresponding to the region with a high gradation value (low-density region in Fig. 3) may be set as the first magnetic domain, and the magnetic domain corresponding to the region with a low gradation value (high-density region in Fig. 3) may be set as the second magnetic domain. In this case, in Fig. 4, the densities (black and white regions) may be reversed, and in the following explanation in Fig. 4, the first magnetic domain may be considered to be a white region.

Fig. 4 illustrates, as an example, the case where all of the template images 410 included in the template image group 400 have the same size and shape. Specifically, Fig. 4 illustrates, as an example, the case where all of the template images 410 are rectangles whose long sides are the same in length and whose short sides are the same in length. The length of the short side of the template image 410 (length in the x-axis direction) may be longer than the maximum value of the width assumed as the magnetic domain width of the magnetic body S, for example. Further, the length of the long side of the template image 410 (length in the y-axis direction) may be 1.2 times or more (preferably 1.5 times or more) and 3 times or less (preferably 2 times or less) the maximum value of the width assumed as the magnetic domain width of the magnetic body S, for example. However, the shape of the template image 410 is not limited to the rectangle, but may be a square, for example.

In Fig. 4, w is the width of the first magnetic domain (black region) illustrated in the template image 410. Fig. 4 illustrates, as an example, for one magnetic domain width, the case where a plurality of template images having the same magnetic domain width but having mutually different magnetic domain directions of the first magnetic domain are included in the template image group 400. Specifically, in Fig. 4, a plurality of template images 410 in which the magnetic domain widths w of the first magnetic domain are $w_1$, which are the same, and whose magnetic domain directions are different mutually are illustrated next to $w_1$. Similarly, in Fig. 4, template images 410 in which the magnetic domain widths w of the first magnetic domain are $w_2, w_3, ..., w_p$ are illustrated next to $w_2, w_3, ..., w_p$ respectively. Incidentally, Fig. 4 illustrates, as an example, the case where of the magnetic domain width of the first magnetic domain illustrated in the template image 410, the maximum value is $w_1$ and the minimum value is $w_p$ ((max) and (min) illustrated below $w_1$ and $w_p$ in Fig. 4 indicate this).

Further, Fig.4 illustrates, as an example, the case where the magnetic domain width w of the first magnetic domain is a width that is shifted by a predetermined width step $\Delta w$ in the range of $w_1$ to $w_p$. However, it is not always necessary to determine the magnetic domain width w of the first magnetic domain in this manner. For example, the width step $\Delta w$ does not need to be a constant value. This embodiment explains, as an example, the case where the resolution of the magnetic domain width w calculated based on the magnetic domain image 300 is determined by the width step $\Delta w$. For example, when increasing the accuracy of the magnetic domain width w is prioritized over reducing a calculation load, the width step $\Delta w$ is reduced, and conversely, when reducing the calculation load of the magnetic domain width w is prioritized over increasing the accuracy of the magnetic domain width w, the width step $\Delta w$ is increased. Therefore, in this embodiment, the resolution of the magnetic domain width w can be adjusted by an operator, and thus is not limited by calculation principles such as the Nyquist sampling theorem explained in the section of Problems to be Solved by the Invention.

Further, in this embodiment, the magnetic domain width w of the first magnetic domain can be adjusted by an operator. Therefore, in this embodiment, even if magnetic domains with a wide magnetic domain width and magnetic domains with a narrow magnetic domain width are both included in the magnetic domain image 300, the magnetic domain widths w of these magnetic domains can be derived without changing the settings for deriving the magnetic domain information. In contrast, in the technique described in Patent Literature 1, in the case where magnetic domains with a wide magnetic domain width and magnetic domains with a narrow magnetic domain width are both included in the magnetic domain image 300, when a window function is set according to the magnetic domain with a wide magnetic domain width, it is impossible to accurately derive the magnetic domain with a narrow magnetic domain width, or it is impossible to derive the magnetic domain with a narrow magnetic domain width in some cases. For this reason, in the technique described in Patent Literature 1, it is necessary to set a plurality of window functions according to the magnetic domain widths.

In Fig. 4, $\theta$ is an angle that represents the magnetic domain direction of the first magnetic domain (black region) illustrated in the template image 410. The magnetic domain direction is a direction vertical to the magnetic domain width direction in an observation surface (surface of the template image 410) (in other words, the magnetic domain width direction is a direction vertical to the magnetic domain direction in the observation surface). In the following explanation, the angle representing the magnetic domain direction is referred to as a magnetic domain angle $\theta$ as necessary. In Fig. 4, below $\theta_1$, template images 410 are illustrated in which the magnetic domain angles $\theta$ of the first magnetic domains are $\theta_1$. Similarly, below $\theta_2$, $\theta_3$, ..., $\theta_q$, template images 410 are illustrated in which the magnetic domain angles $\theta$ of the first magnetic domains are $\theta_2$, $\theta_3$, ..., $\theta_q$, respectively. Incidentally, Fig. 4 illustrates, as an example, the case where the magnetic domain angle $\theta$ of the first magnetic domain is represented by an angle (righthanded angle) with the counterclockwise direction on the paper sheet set as the positive direction, starting from a straight line pointing in the positive direction of the x-axis. Further, as described previously, the origin of the coordinate system illustrated in Fig. 4 is set at the position of the lower left corner of each template image 410. Therefore, in Fig. 4, the magnetic domain angle $\theta_1$ of the first magnetic domain is 90° ((= 90°) illustrated next to $\theta_1$ in Fig. 4 indicates this).

Further, Fig. 4 illustrates, as an example, the case where the magnetic domain angle $\theta$ of the first magnetic domain is an angle that is shifted by a predetermined angle step $\Delta\theta$ in the range of 0° or more and less than 180°. For example, when the angle step $\Delta\theta$ is 5°, the magnetic domain angle $\theta$ of the first magnetic domain is 0°, 5°, 10°, ..., 170°, and 175°. However, it is not always necessary to determine the magnetic domain angle $\theta$ of the first magnetic domain in this manner. For example, the angle step $\Delta\theta$ does not need to be a constant value. Further, the range of the magnetic domain angle $\theta$ of the first magnetic domain may be narrower than the range of 0° or more and less than 180°. This embodiment explains, as an example, the case where the resolution of the magnetic domain angle $\theta$ calculated based on the magnetic domain image 300 is determined by the angle step $\Delta\theta$. Therefore, in this embodiment, the resolution of the magnetic domain angle $\theta$ can also be adjusted by an operator, similarly to the magnetic domain width w, and thus is not limited by calculation principles such as the Nyquist sampling theorem explained in the section of Problems to be Solved by the Invention. Incidentally, when the shape of the first magnetic domain in the template image 410 differs between when the magnetic domain angle $\theta$ is in the range of 0° or more and 180° or less and when the magnetic domain angle $\theta$ is in the range of 180° or more and 360° or less, the magnetic domain angle $\theta$ may be in the range of 0° or more and less than 360°.

Further, Fig. 4 illustrates, as an example, the case where in the template image 410, the shape of the first magnetic domain (black region) is a rectangle when the magnetic domain angle $\theta$ is n × 90° (n is 0 or 1), and the gravity center position of the rectangle coincides with the gravity center position of the template image 410. Further, Fig. 4 illustrates, as an example, the case where the shape of the first magnetic domain when the magnetic domain angle $\theta$ is other than n × 90° is a shape obtained by rotating the first magnetic domain when the magnetic domain angle $\theta$ is n × 90° (n is 0 or 1) by $\theta$° around the gravity center position (however, in this case, the end of the first magnetic domain (black region) in the magnetic domain direction is aligned with the end of the template image 410). However, the size and shape of the first magnetic domain in the template image are not limited to these. For example, the shape of the first magnetic domain in the template image may be a square or an ellipse. When the shape of the first magnetic domain in the template image is an ellipse, for example, the minor axis of the ellipse may be the magnetic domain width of the first magnetic domain in the template image. Further, the direction of the major axis of the ellipse may be the magnetic domain direction of the first magnetic domain in the template image.

Further, this embodiment explains, as an example, the case where in the template image 410, the pixel value of the first magnetic domain is the minimum gradation value (= 0) and the pixel value of the second magnetic domain is the maximum gradation value (= 255). However, the pixels of the first magnetic domain in the template image 410 may include pixels with pixel values that exceed the minimum gradation value. Further, the pixels of the second magnetic domain in the template image 410 may include pixels with pixel values that are below the maximum gradation value. Further, the pixel value of the first magnetic domain in the template image 410 may be made to differ depending on the position of the first magnetic domain. Similarly, the pixel value of the second magnetic domain in the template image 410 may be made to differ depending on the position of the second magnetic domain.

Further, as illustrated in Fig. 3, this embodiment explains, as an example, the magnetic domain image 300 of the magnetic body S that is capable of obtaining a magnetic domain structure in which magnetic domains whose orientations of magnetic moments are reversed in a direction approximately parallel to the y-axis are aligned alternately one by one in the x-axis direction. Then, as illustrated in Fig. 4, this embodiment explains, as an example, the case where the plural template images 410 corresponding to such a magnetic domain image 300 are created. However, the magnetic domain structure of the magnetic body S is not limited to such a magnetic domain structure. The magnetic domain image to which this embodiment is to be applied may be, for example, a magnetic domain image of the magnetic body S having a 90° magnetic domain wall in addition to or instead of the 180° magnetic domain wall. Template images only need to be prepared according to the magnetic domain structure expected in the magnetic body S.

Further, at least one of enlargement and reduction may be performed on the template image 410 included in the template image group 400. In this case, for example, it is preferable that at least one of enlargement and reduction should be performed on the template image 410 so as to prevent the length in the magnetic domain direction of the magnetic domains (first magnetic domain and second magnetic domain) included in the template image 410 from becoming too short.

Specifically, for example, it is preferable to enlarge the template image 410 so as to make the enlargement ratio in the magnetic domain width direction smaller than that in the magnetic domain direction. Further, it is preferable to enlarge the template image 410 so as to make the reduction ratio in the magnetic domain width direction smaller than that in the magnetic domain direction. This is to make it easier to distinguish the magnetic domains (first magnetic domain and second magnetic domain) included in the template image 410 from the noise contained in the magnetic domain image 300, for example. For example, enlargement and reduction may be performed on the template image 410 in the magnetic domain width direction (the x-axis direction in Fig. 4), which includes the first magnetic domain whose magnetic domain angle $\theta$ is 0°, without changing the length of the template image 410 in the magnetic domain direction (the y-axis direction in Fig. 4), which includes the first magnetic domain whose magnetic domain angle $\theta$ is 0°. However, for example, the entire template image 410 may be enlarged at the same enlargement ratio. Further, for example, the entire template image 410 may be reduced at the same reduction ratio.

Returning to the explanation in Fig. 2B, as described previously, the template setting information is information necessary for creating the plural template images 410. When creating the template images 410 illustrated in Fig. 4 as an example, for example, pieces of information on the maximum value $w_1$, the minimum value $w_p$, and the width step $\Delta_w$ are included in the template setting information as information for identifying the magnetic domain width w of the first magnetic domain. Further, for example, pieces of information on the maximum value, the minimum value, and the angle step $\Delta\theta$ of the magnetic domain angle $\theta$ of the first magnetic domain are included in the template setting information as information for identifying the magnetic domain angle $\theta$ of the first magnetic domain.

As described previously, this embodiment explains, as an example, the case where the acquisition part 211 acquires the threshold value information in addition to the magnetic domain image 300 and the template setting information. The threshold value information is information indicating a threshold value to be used in the later-described comparison part 213. The details will be described later in the section <<Comparison part 213>>, but the threshold value is a threshold value for the degree of match between the region to be compared of the magnetic domain image 300 and the template image 410.

This embodiment explains, as an example, the case where an operator performs an operation to input information indicating the template setting information and the threshold value information to the input device 220. In this case, the input device 220 includes a user interface. This embodiment explains, as an example, the case where the acquisition part 211 acquires the template setting information and the threshold value information input by the input operation to the input device 220. However, the form of acquiring the template setting information and the threshold value information is not limited. The acquisition part 211 may acquire the template setting information and the threshold value information by the input device 220 receiving the template setting information and the threshold value information transmitted from an external device, for example. In this case, the input device 220 includes a receiver. Further, the acquisition part 211 may acquire the template setting information and the threshold value information by reading out the template setting information and the threshold value information stored in a storage medium included in the input device 220.

<<Creation part 212>>

A creation part 212 creates a plurality of template images 410 based on the template setting information acquired in the acquisition part 211. This embodiment explains, as an example, the case where the creation part 212 creates the plural template images 410 illustrated in Fig. 4 as an example. In this manner, this embodiment explains, as an example, the case where the processing device 200 (the creation part 212) creates the plural template images 410. However, this embodiment does not necessarily need to be designed in this manner. For example, the acquisition part 211 may acquire the plural template images 410. In this case, the acquisition part 211 does not need to acquire the template setting information. The form of acquiring the plural template images 410 may be the same as the form of acquiring the template setting information explained in the section <<Acquisition part 211>>, for example.

<<Comparison part 213>>

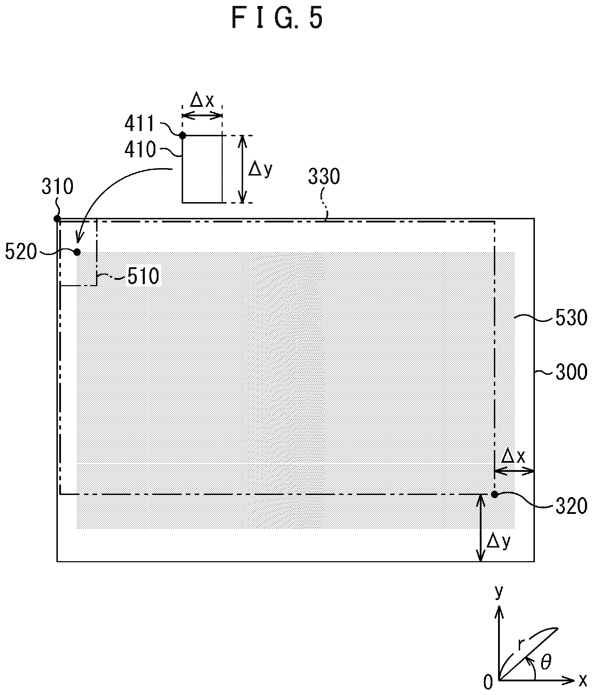

The comparison part 213 compares the region to be compared 510 of the magnetic domain image 300 with the template image 410 (see Fig. 5). The region to be compared 510 is a region of at least a portion of the magnetic domain image 300. The region to be compared 510 includes a pixel to be compared 520. The region to be compared 510 is a partial region (a region of a portion) of the magnetic domain image 300 to be compared with the template image 410, for example. The pixel to be compared 520 is a pixel at a position where magnetic domain information is obtained. The pixel to be compared 520 is set at a predetermined position (for example, the gravity center position, which is referred to as a representative position below) of the region to be compared 510. The pixel at the position where the magnetic domain information is obtained is a pixel at a position within the region to be compared 520 where magnetic domain information derived by the comparison by the comparison part 213 is reflected, among the pixels of the magnetic domain image 300. The size (length and width) of the region to be compared 510 may be, for example, a single pixel, or a group of plural pixels. The group of plural pixels is, for example, a plurality of pixels included within a circle, rectangle, and polygon having a predetermined size.

This embodiment explains, as an example, the case where the pixel to be compared 520 is composed of a single pixel. Further, this embodiment explains, as an example, the case where magnetic domain information is obtained at each pixel to be compared 520 by the comparison with plural template images. That is, the comparison part 213 compares an image portion (the region to be compared 510) including a pixel (the pixel to be compared 520) at a position where magnetic domain information is to be obtained with each of the plural template images 410. Fig. 5 illustrates, as an example, the case where there are plural image portions (regions to be compared 510) each including a pixel (the pixel to be compared 520) at a position where magnetic domain information is to be obtained. In this case, the comparison part 213 compares each of the regions to be compared 510 each including the pixel to be compared 520 with the template image 410. For example, when obtaining the magnetic domain information over the entire magnetic domain image 300, the comparison part 213 selects all pixels included in the entire magnetic domain image 300 as the pixel to be compared 520, thereby making it possible to derive magnetic domain information at all of the pixels included in the entire magnetic domain image 300. For example, the comparison part 213 may compare the region to be compared 510 with the template image 410 while shifting a pixel in the magnetic domain image 300 to be selected as the pixel to be compared 520 by a predetermined interval (for example, one pixel) so that all pixels that can be selected from the template image 410 are selected as the pixel to be compared 520. Incidentally, for example, when it is only necessary to obtain magnetic domain information in the region of a portion of the magnetic domain image 300, it is sufficient to derive the magnetic domain information in the region of this portion. Thus, it is not always necessary to derive the magnetic domain information at all of the pixels included in the entire magnetic domain image 300.

By this comparison by the comparison part 213, comparison results such as the degree of match, for example, are obtained, so that it is possible to derive the magnetic domain information at the pixel to be compared 520 from magnetic domain information on each of the template images 410 based on the comparison results. In other words, the magnetic domain information on the template image 410 obtained as a result of the comparison of the region to be compared 510 with the template image 410 is reflected as the magnetic domain information at the pixel to be compared 520 in the region to be compared 510, thereby making it possible to derive the magnetic domain information in the region to be compared 520. Incidentally, the number of template images 410 may be one. In this case, for example, whether or not the magnetic domain information at the pixel to be compared 520 to be compared is the same as the magnetic domain information on the single template image 410, which is used for the comparison with the region to be compared 510, may be determined. Further, for example, the relationship in size between the magnetic domain width in the single template image 410, which is used for the comparison with the region to be compared 510, and the magnetic domain width in the region to be compared 510 may be determined. Further, the region to be compared 510 generally includes the pixel to be compared 520 and its surrounding pixels. However, the region to be compared 510 and the pixel to be compared 520 may coincide with each other.

In the following explanation, this embodiment explains, as an example, the case where the comparison part 213 calculates the degree of match between the region to be compared 510 and each of the plural template images 410 by so-called template matching (incidentally, the degree of match is also referred to as the degree of similarity, or the like). More specifically, in this embodiment, the comparison part 213 determines which template image 410 matches at each position while shifting the region to be compared 510 within a scanning region 330 set in the magnetic domain image to be processed. For example, the comparison part 213 may perform processing as follows.

Fig. 5 is a view conceptually illustrating an example of a method of comparing the region to be compared 510 with the template image 410.
Fig. 5 illustrates, as an example, the case where when a pixel 411 at the upper left corner of the template image 410 is located at one pixel in the rectangular scanning region 330 having opposite vertices 310 and 320, and the template image 410 is superimposed on the magnetic domain image 300 so that the x-axis direction and the y-axis direction of the template image 410 are parallel to the x-axis direction and the y-axis direction of the magnetic domain image 300 respectively, the region of the magnetic domain image 300 that overlaps the template image 410 becomes the region to be compared 510.

Fig. 5 illustrates, as an example, the case where the vertex 310 of the scanning region 330 is the pixel at the upper left corner of the magnetic domain image 300. In this case, a distance $\Delta x$ in the x-axis direction from the vertex 320 (one of the opposite vertices 310 and 320 described previously) of the scanning region 330 to the end of the magnetic domain image 300 in the positive direction of the x-axis is the length of the template image 410 in the x-axis direction. Further, a distance $\Delta y$ in the y-axis direction from the vertex 320 of the scanning region 330 to the end of the magnetic domain image 300 in the negative direction of the y-axis is the length of the template image 410 in the y-axis direction.

In this manner, the comparison part 213 sets the region to be compared 510 for one pixel in the scanning region 330. Further, the comparison part 213 sets the pixel at the representative position of the region to be compared 510 as the pixel to be compared 520 of the region to be compared 510. Fig. 5 illustrates, as an example, the case where the representative position is the gravity center position. However, the representative position is not limited to the gravity center position. The representative position may be, for example, the position at the upper left corner. Fig. 5 illustrates, as an example, the case where the region to be compared 510 has been determined for the pixel at the position of the vertex 310 of the upper left corner of the scanning region 330.

Then, the comparison part 213 calculates the degree of match between the region to be compared 510 and each of the plural template images 410. As the degree of match, an index that is generally used in template matching may be used. For example, the degree of match may be SSD (Sum of Squared Difference (SSD) or SAD (Sum of Absolute Difference). Incidentally, SAD is the sum of absolute values of the difference between the pixel value of the template image 410 and the pixel value of the region to be compared 510. Further, SSD is the sum of squares of the difference between the pixel value of the template image 410 and the pixel value of the region to be compared 510.

Incidentally, the comparison part 213 does not necessarily need to calculate the degree of match as a calculation for comparing the region to be compared 510 with the template image 410. For example, 230 may calculate the degree of mismatch instead of the degree of match. For example, the value obtained by multiplying SSD or SAD by -1 may be calculated as the degree of mismatch.

In this manner, the comparison part 213 sets the region to be compared 510 for one pixel in the scanning region 330. Then, the comparison part 213 calculates the degree of match between the region to be compared 510 and each of the plural template images 410. The comparison part 213 performs such a calculation of the degree of match by selecting each one of all of the pixels in the scanning region 330 as the pixel to be compared 520. Thereby, the degree of match is calculated for all of the pixels in the scanning region 330. Incidentally, as long as all of the pixels in the scanning region 330 are selected as the pixel to be compared 520, pieces of magnetic domain information are derived at all of the pixels in the scanning region 330, which is preferable. However, it is not always necessary to select all of the pixels in the scanning region 330 as the pixel to be compared 520.

Incidentally, the order in which the comparison part 213 selects one pixel in the scanning region 330 is not limited. The following may be performed sequentially from the top row to the bottom row of the scanning region 330, in which for example, pixels in the top row are each selected while shifting by one pixel in the positive direction of the x-axis and then pixels in the row, which is one row therebelow, are each selected while shifting by one pixel in the positive direction of the x-axis so that the vertex 310 at the upper left corner of the scanning region 330 is selected first and the vertex 320 at the lower right corner is selected last.

When the comparison part 213 selects one pixel in the scanning region 330, the pixel to be compared 520 in the region to be compared 510 is set in a region 530 of a portion of the magnetic domain image 300 (the region 530 is illustrated in gray), and is not set in the entire region of the magnetic domain image 300. In the following explanation, this region 530 is referred to as a pixel to be compared setting region 530 as necessary. In general, the magnetic domain image 300 is an image of a region of a portion of the magnetic body S. Therefore, regarding the region of the magnetic domain image 300 other than the pixel to be compared setting region 530, the comparison part 213 may use another not-illustrated magnetic domain image adjacent to the region to calculate the degree of match between the region to be compared 510 and each of the plural template images 410. However, this embodiment does not necessarily need to be designed in this manner. For example, the comparison part 213 does not need to calculate the degree of match between the region to be compared 510 and each of the plural template images 410 in the region of the magnetic domain image 300 other than the pixel to be compared setting region 530.

Incidentally, as illustrated in Fig. 4, this embodiment explains, as an example, the case where the magnetic domain angles $\theta$ illustrated in at least two of the plural template images 410 are different. However, this embodiment does not necessarily need to be designed in this manner. For example, in Fig. 4, the plural template images 410 illustrating the first magnetic domains having the plural magnetic domain widths $w_1$ to $w_p$ at only one magnetic domain angle $\theta_1$ may be prepared as the template image group 400. In this case, the comparison part 213 may rotate the region to be compared 510 by the angle step $\Delta\theta$ without rotating the template image 410, for example. In this case, the comparison part 213 may superimpose the rotated region to be compared 510 on the template image 410, to thereby make the magnetic domain direction illustrated in the template image 410 different from the magnetic domain direction illustrated in the region to be compared 510. Incidentally, for example, when this embodiment is designed in this manner and the magnetic domain angle θ is derived without deriving the magnetic domain width w as the magnetic domain information, the number of template images 410 may be one. Further, the comparison part 213 may rotate the region to be compared 510 instead of or in addition to rotating the template image 410, for example.

<<Magnetic domain information deriving part 214>>

A magnetic domain information deriving part 214 derives magnetic domain information at the pixel to be compared 520 in the region to be compared 510 based on the result of comparison by the comparison part 213. This embodiment explains, as an example, the case where the magnetic domain information deriving part 214 determines whether or not the result of comparison of the region to be compared 510 with each of the plural template images 410 satisfies a predetermined condition. Then, this embodiment explains, as an example, the case where the magnetic domain information deriving part 214 derives magnetic domain information at the pixel to be compared 520 in the region to be compared 510 based on the magnetic domain information on the template image 410 that satisfies the predetermined condition when the result of comparison satisfies the predetermined condition. The predetermined condition may be any condition that determines whether or not there is a template image 410 that matches or is similar to the region to be compared 510. This embodiment explains, as an example, the case where the magnetic domain information deriving part 214 determines whether or not the maximum value of the degree of match out of the degrees of match between the region to be compared 510 and each of the plural template images 410 exceeds a threshold value.

In this case, for example, when there are plural template images 410 whose degrees of match with the region to be compared 510 exceed a threshold value, the magnetic domain information deriving part 214 may derive magnetic domain information at the pixel to be compared 520 in the region to be compared 510 based on the template image 410 out of the plural template images 410 that has the maximum degree of match. This embodiment explains, as an example, the case where the magnetic domain information is the magnetic domain width w and the magnetic domain angle θ. However, the magnetic domain information is not limited to the magnetic domain width w or the magnetic domain angle θ. For example, only one of the magnetic domain width w and the magnetic domain angle θ may be set as the magnetic domain information. In the following explanation, the magnetic domain information derived by the magnetic domain information deriving part 214 is referred to simply as magnetic domain information as necessary.

For example, as illustrated in Fig. 4, when the information on the magnetic domain width w and the magnetic domain angle θ is associated with the template images 410, the magnetic domain information deriving part 214 may derive magnetic domain information by reading out the magnetic domain width w and the magnetic domain angle θ associated with the template image 410 that has the maximum degree of match with the region to be compared 510 as the magnetic domain information at the pixel to be compared 520 in the region to be compared 510. Further, for example, when the information on the magnetic domain width w and the magnetic domain angle θ is not associated with the template images 410, the magnetic domain information deriving part 214 may derive magnetic domain information by calculating the magnetic domain angle θ and the magnetic domain width w of the first magnetic domain based on the pixel value of the template image 410 that has the maximum degree of match with the region to be compared 510. For example, the magnetic domain information deriving part 214 may identify the boundary between the first magnetic domain and the second magnetic domain (the region corresponding to the magnetic domain wall), and calculate the magnetic domain angle θ and the magnetic domain width w of the first magnetic domain based on the direction in which the identified boundary extends and the length of the first magnetic domain in a direction vertical to the direction.

As above, this embodiment explains, as an example, the case where when the maximum value of the degree of match with the region to be compared 510 exceeds a threshold value, the magnetic domain information deriving part 214 derives magnetic domain information (the magnetic domain width w and the magnetic domain angle θ) at the pixel to be compared 520 in the region to be compared 510. Thus, the magnetic domain information (the magnetic domain width w and the magnetic domain angle θ) is derived at each pixel (pixel to be compared 520) in the pixel to be compared setting region 530 illustrated in Fig. 5. Incidentally, the magnetic domain information does not need to or may indicate that the magnetic domain width w and the magnetic domain angle θ are those of the first magnetic domain.

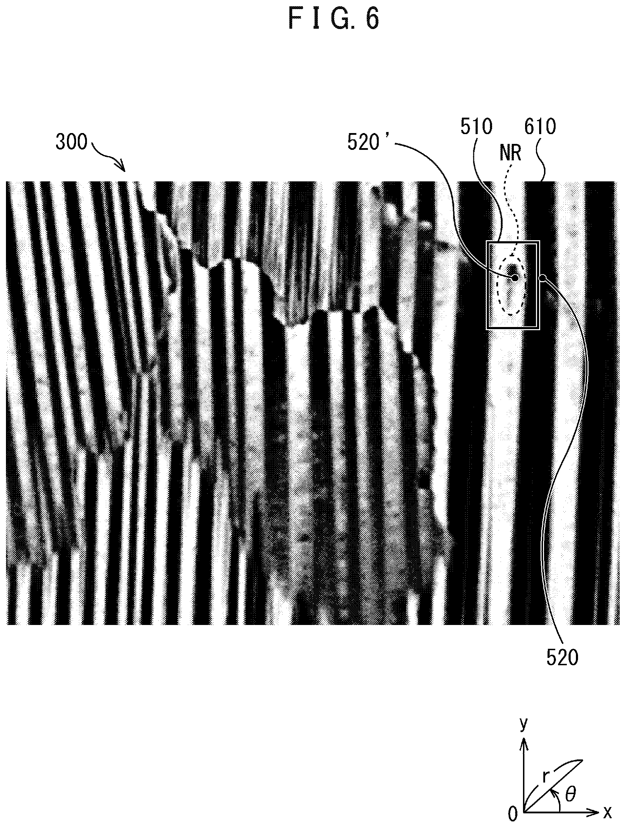

On the other hand, this embodiment explains, as an example, the case where the magnetic domain information deriving part 214 does not derive magnetic domain information at the pixel to be compared 520 in the region to be compared 510 when the maximum value of the degree of match with the region to be compared 510 does not exceed the threshold value. In this case, the magnetic domain information deriving part 214 may set the pixel to be compared 520 where magnetic domain information has not been derived as a blank pixel indicating that magnetic domain information has not been derived. Thus, the blank pixel is also a pixel to be compared, but in order to distinguish it from the pixel to be compared 520, the reference numeral of the blank pixel is set to 520' (see Fig. 6 to be described later).

However, the magnetic domain information deriving part 214 does not necessarily need to set the blank pixel 520'. For example, the magnetic domain information deriving part 214 may derive magnetic domain information as described previously based on the template image 410 that has the maximum degree of match with the region to be compared 510, regardless of whether or not the maximum value exceeds the threshold value. In this case, the magnetic domain information deriving part 214 does not need to compare the maximum value of the degree of match with the threshold value. Further, a later-described supplementary magnetic domain information deriving part 215 becomes unnecessary.

Incidentally, as described previously, this embodiment explains, as an example, the case where the magnetic domain information deriving part 214 calculates the maximum value of the degree of match between the region to be compared 510 and the plural template images 410, and determines whether or not the calculated maximum value of the degree of match exceeds the threshold value. However, a determination condition is not limited to such a condition. For example, the magnetic domain information deriving part 214 may determine whether or not the maximum value is equal to or more than the threshold value instead of whether or not the maximum value exceeds the threshold value. Further, when the comparison part 213 calculates the degree of mismatch between the region to be compared 510 and the plural template images 410, the magnetic domain information deriving part 214 may calculate the minimum value of the degree of mismatch and determine whether or not the calculated minimum value of the degree of mismatch is equal to or less than the threshold value (or is lower than the threshold value).

The template matching is generally used to extract objects within an image. For this reason, the template matching technique generally requires that a single object within an image should be entirely contained within one template image. In this embodiment, the entire magnetic domain (the entirety of a stripe extending approximately in the vertical direction (y-axis direction)) in the magnetic domain image 300 needs to be contained in one template image. Therefore, even if a general template matching technique could be applied to the magnetic domain image, the only thing that could be obtained would be performing template matching to extract each individual magnetic domain from the magnetic domain image. However, even the magnetic domain image 300 illustrated in Fig. 3 as an example alone exhibits a variety of magnetic domain shapes. In other words, there are innumerable shapes of magnetic domains. Therefore, the number of template images is also innumerable. Therefore, it can be considered that the magnetic domain image is not suitable for the template matching technique generally.

In contrast to this, in this embodiment, the template matching technique is used for deriving magnetic domain information rather than deriving the entire magnetic domain included in the magnetic domain image. As has been explained with reference to Fig. 4 and Fig. 5, the magnetic domain information (for example, the magnetic domain width w and the magnetic domain angle θ) can be quantitatively derived by comparing the region (the region to be compared 510) of a portion of the magnetic domains projected on the magnetic domain image 300 with the template image 410. The region (the region to be compared 510) of a portion of the magnetic domains projected on the magnetic domain image 300 only needs to have a size that allows magnetic domain information (for example, the magnetic domain width w and the magnetic domain angle θ) to be obtained. A plurality of magnetic domains that are mutually different in overall shape include regions that are partially the same or similar in shape. Further, within a single magnetic domain, there are a plurality of regions that are partially the same or similar in shape. Therefore, there is no need to prepare an innumerable number of template images 410. As described above, this embodiment does not use the template matching for extracting the magnetic domain included in the magnetic domain image 300, but uses the template matching as a method for quantitatively deriving the magnetic domain information included in the magnetic domain image 300.

<Supplementary magnetic domain information deriving part 215>

The supplementary magnetic domain information deriving part 215 derives magnetic domain information at the blank pixel 520' based on at least one piece of the magnetic domain information derived by the magnetic domain information deriving part 214. As described previously, the blank pixel 520' is the pixel to be compared 520 where magnetic domain information was not derived by the magnetic domain information deriving part 214. Further, as described previously, this embodiment explains, as an example, the case where the magnetic domain information is the magnetic domain width w and the magnetic domain angle θ. In the following explanation, the magnetic domain information derived by the supplementary magnetic domain information deriving part 215 is referred to as supplementary magnetic domain information as necessary.

In the template image 410 illustrated in Fig. 4 as an example, the magnetic domain width w and the magnetic domain angle θ of the first magnetic domain (the region with a low gradation value (the high-density region in Fig. 3)) are determined. Therefore, when the region to be compared 510 is similar to the first magnetic domain, there is a high possibility that magnetic domain information will be derived by the magnetic domain information deriving part 214. In other words, when a region of interest 510 that draws attention is not similar to the first magnetic domain but is similar to the second magnetic domain (the region with a high gradation value (the low-density region in Fig. 3)), there is a high possibility that no magnetic domain information will be derived by the magnetic domain information deriving part 214. However, pieces of magnetic domain information (the magnetic domain widths w and the magnetic domain angles θ in the example of this embodiment) of plural magnetic domains that are present at positions close to each other (for example, positions adjacent to each other) do not differ significantly regardless of the first magnetic domain and the second magnetic domain. Thus, this embodiment explains, as an example, the case where the supplementary magnetic domain information deriving part 215 selects at least one piece of the magnetic domain information derived by the magnetic domain information deriving part 214 based on the position of the blank pixel 520' and the position of the pixel to be compared 520 where the magnetic domain information has been derived by the magnetic domain information deriving part 214. In this case, the supplementary magnetic domain information deriving part 215 may calculate magnetic domain information (supplementary magnetic domain information) at the blank pixel 520' based on the selected magnetic domain information. It is preferable that the position of the blank pixel 520' and the position of the pixel to be compared 520 should be adjacent to each other.

For example, the supplementary magnetic domain information deriving part 215 may select the magnetic domain information at the pixel to be compared 520 having the shortest Euclidean distance to the blank pixel 520' out of the pixels to be compared 520 where the magnetic domain information has been derived by the magnetic domain information deriving part 214. In this case, the supplementary magnetic domain information deriving part 215 may derive supplementary magnetic domain information by setting the selected magnetic domain information as the magnetic domain information at the blank pixel 520'.

Further, the supplementary magnetic domain information deriving part 215 may select plural pixels to be compared 520 from among the pixels to be compared 520 where the magnetic domain information has been derived by the magnetic domain information deriving part 214 in order of the shortest distance, such as the Euclidean distance to the blank pixel 520'. The number of the selected plural pixels to be compared 520 is a predetermined number, or the like. The supplementary magnetic domain information deriving part 215 may calculate magnetic domain information at the blank pixel 520' based on pieces of the magnetic domain information at the selected plural pixels to be compared 520. For example, the supplementary magnetic domain information deriving part 215 may calculate a statistical value such as the average value, the mode value, or the weighted linear sum of the magnetic domain widths w (pieces of the magnetic domain information) at the selected plural pixels to be compared 520' as the magnetic domain width w at the blank pixel 520'. In the case of the weighted linear sum, a weighting coefficient for the magnetic domain width w at the pixel to be compared 520 may be determined according to the Euclidean distance between the pixel to be compared 520 and the blank pixel 520'. For example, the weighting coefficient for the magnetic domain width w at each of the pixels to be compared 520 may be set to be larger as the Euclidean distance to the blank pixel 520' is shorter. As for the magnetic domain angle $\theta$ as well, the supplementary magnetic domain information deriving part 215 may calculate a weighted linear sum of the magnetic domain angles $\theta$ at the plural pixels to be compared 520 as the magnetic domain angle $\theta$ at the blank pixel 520', similarly to the magnetic domain width w.

As described above, this embodiment explains, as an example, the case where the supplementary magnetic domain information (the magnetic domain width w and the magnetic domain angle $\theta$) can be derived at each pixel (pixel to be compared 520) in the pixel to be compared setting region 530 illustrated in Fig. 5. Incidentally, the supplementary magnetic domain information does not need to or may indicate that the magnetic domain width w and the magnetic domain angle $\theta$ are not those of the first magnetic domain (or are those of the second magnetic domain).

Fig. 6 is a view explaining why it is difficult for a region that is not a magnetic domain to be detected as a magnetic domain in the method of this embodiment. The region NR illustrated in Fig. 3 as an example can also be seen as a magnetic domain when viewed locally because the black portion extends along the y-axis direction and there are white portions on both sides of the black portion in the x-axis direction. In the technique described in Patent Literature 1, such a region NR is easily detected as a magnetic domain.

In contrast to this, in this embodiment, the degree of match between the region to be compared 510 when the region NR overlaps the pixel to be compared 520 and each of the template images 410 in the template image group 400 illustrated in Fig. 4 becomes low. Therefore, the magnetic domain information is not easily derived (namely, the pixel to be compared 520 in the region NR is more likely to be set as the blank pixel 520'). In this case, magnetic domain information (supplementary magnetic domain information) at the blank pixel 520' in the region NR is derived using the magnetic domain information at the pixel to be compared 520 at a position close to the blank pixel 520'.

For example, assume that the pixel to be compared 520 at the position illustrated in Fig. 6 is the pixel to be compared 520 that has the shortest Euclidean distance to the blank pixel 520' in the region NR illustrated in Fig. 6 out of the pixels to be compared 520 where the magnetic domain information has been calculated. Further, assume that the magnetic domain information at the pixel to be compared 520 is the magnetic domain width w and the magnetic domain angle $\theta$ of a first magnetic domain 610. Then, assume that the magnetic domain information at the pixel to be compared 520 that has the shortest Euclidean distance to the blank pixel 520' is derived as the magnetic domain information (supplementary magnetic domain information) at the blank pixel 520'. In this case, the magnetic domain information (supplementary magnetic domain information) at the blank pixel 520' is the magnetic domain width w and the magnetic domain angle $\theta$ of the first magnetic domain 610. Therefore, the region NR is not detected as noise, and the magnetic domain width w and the magnetic domain angle $\theta$ close to the magnetic domain width w and the magnetic domain angle $\theta$ of the second magnetic domain (low-density region) surrounding the region NR are derived as the magnetic domain information in the region NR.

<<Output part 216>>

An output part 216 outputs all magnetic domain information including all pieces of the magnetic domain information derived by the magnetic domain information deriving part 214 and all pieces of the supplementary magnetic domain information derived by the supplementary magnetic domain information deriving part 215. This embodiment explains, as an example, the case where information including the magnetic domain width w and the magnetic domain angle $\theta$ at each of the pixels to be compared 520 in the pixel to be compared setting region 530 is included in the all magnetic domain information. Further, positions in the magnetic domain image may be associated with the all magnetic domain information (each magnetic domain information derived by the magnetic domain information deriving part 214 and the supplementary magnetic domain information derived by the supplementary magnetic domain information deriving part 215).

This embodiment explains, as an example, the case where the output part 216 outputs the all magnetic domain information to the output device 230. This embodiment explains, as an example, the case where the output device 230 displays the all magnetic domain information. In this case, for example, the output device 230 may include a computer display. Further, the output device 230 may include a storage medium. In this case, for example, the all magnetic domain information stored in the storage medium included in the output device 230 may be used by the processing device 200 and an external device. Further, the output device 230 may also include a transmitter. In this case, for example, the output device 230 transmits the all magnetic domain information to the external device. The communication between the output device 230 and the external device may be wire communication, radio communication, or communication via a network.

<Flowchart>

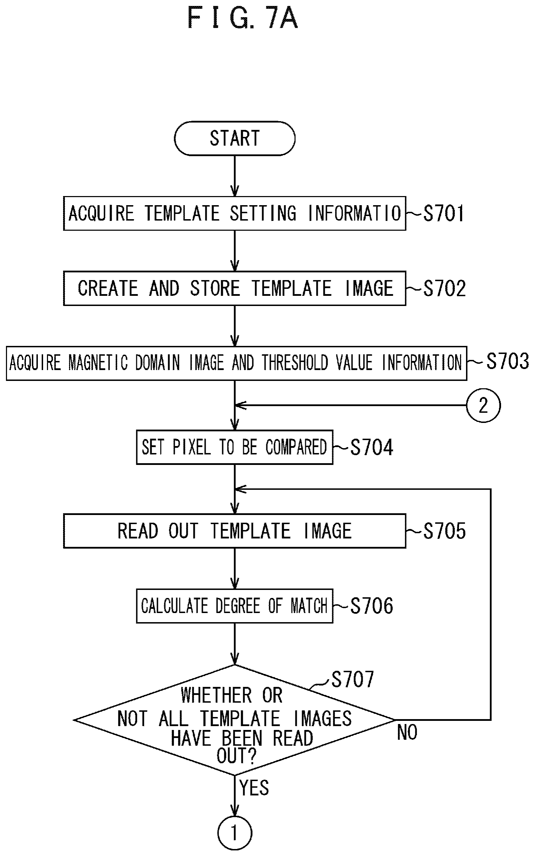

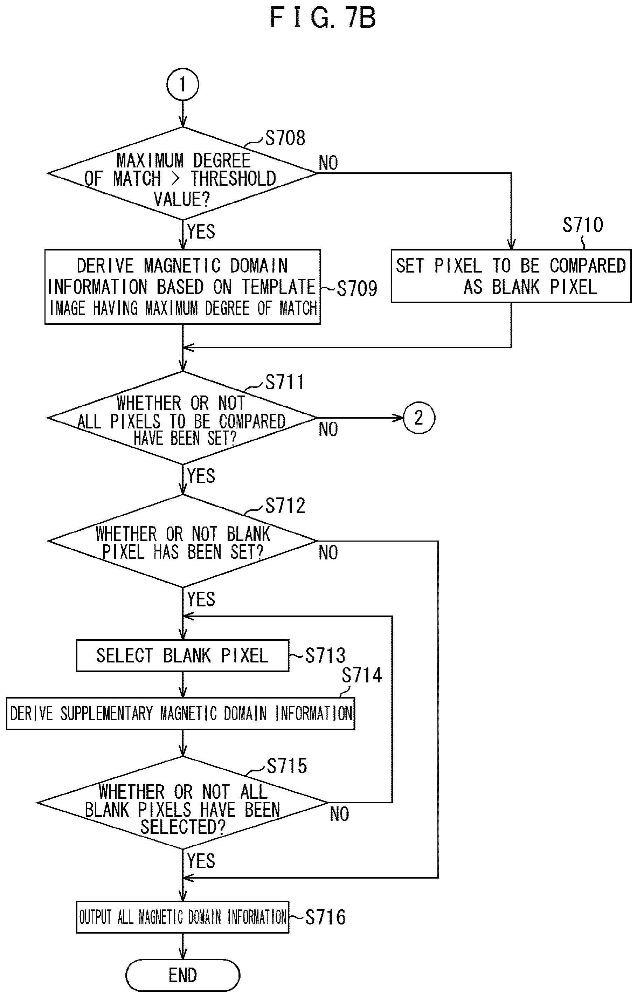

Next, there is explained an example of a processing method to be performed using the processing device 200 in this embodiment with reference to flowcharts in Fig. 7A and Fig. 7B. The flowcharts in Fig. 7A and Fig. 7B are achieved, for example, by a processor included in the processing device 200 expanding a program stored in a memory in the memory and executing it.

First, at Step S701, the acquisition part 211 acquires the template setting information. The template setting information is information necessary for creating the plural template images 410. In the template setting information, for example, pieces of information on the maximum value $w_1$, the minimum value $w_p$, and the width step $\Delta w$ are included as information for identifying the magnetic domain width w of the first magnetic domain. Further, in the template setting information, for example, pieces of information on the maximum value, the minimum value, and the angle step $\Delta\theta$ of the magnetic domain angle $\theta$ of the first magnetic domain are included as information for identifying the magnetic domain angle $\theta$ of the first magnetic domain.

Then, at Step S702, the creation part 212 creates and stores the plural template images 410 based on the template setting information NR acquired at Step S701.

Then, at Step S703, the acquisition part 211 acquires the magnetic domain image 300 of the magnetic body S and the threshold value information. The threshold value information is information indicating a threshold value that is compared with the maximum degree of match out of the degrees of match between the region to be compared 510 and each of the plural template images 410 at Step S708 in Fig. 7B to be described later.

Then, at Step S704, the comparison part 213 determines the region to be compared 510 for one pixel in the scanning region 330, and sets a pixel at the representative position (for example, the gravity center position) of the determined region to be compared 510 as the pixel to be compared 520 of the region to be compared 510. In this embodiment, the pixel to be compared 520 is set for the pixel to be compared setting region 530. At Step S704, the region to be compared with the template image 410 to be read out at the following Step S705 is set as the region to be compared 510.

Then, at Step S705, the comparison part 213 reads out one of the plural template images 410 stored at Step S702.

Then, at Step S706, the comparison part 213 calculates the degree of match between the region to be compared 510 where the pixel to be compared 520 was set at Step S704 and the template image 410 read out at Step S705.

Then, at Step S707, the comparison part 213 determines whether or not all of the plural template images 410 stored at Step S702 (the plural template images 410 included in the template image group 400) have been read out. As a result of this determination, when all of the plural template images 410 stored at Step S702 have not been read out (in the case of NO at Step S707), the processing at Step S705 is performed again. Then, at Step S705, one new template image 410 is read out. Further, at Step S706, the degree of match between the region to be compared 510 where the pixel to be compared 520 was set at Step S704 and the new read-out template image 410 is calculated. Pieces of the processing at Steps S705 to S707 are performed repeatedly until it is determined at Step S707 that all of the plural template images 410 stored at Step S702 have been read out.

Then, when it is determined at Step S707 that all of the plural template images 410 stored at Step S702 have been read out (in the case of YES at Step S707), the processing at Step S708 in Fig. 7B is performed. At Step S708, the magnetic domain information deriving part 214 determines whether or not the maximum value of the degrees of match between the region to be compared 510 where the pixel to be compared 520 was set at Step S704 and each of the template images 410 read out at Step S705 exceeds the threshold value indicated in the threshold value information acquired at Step S703.

As a result of this determination, when the maximum value of the degrees of match between the region to be compared 510 and each of the template images 410 exceeds the threshold value (in the case of YES at S708), the processing at Step S709 is performed.

At Step S709, the magnetic domain information deriving part 214 derives, based on out of the plural template images 410 stored at Step S702, the template image 410 that has the maximum degree of match with the region to be compared 510 where the pixel to be compared 520 was set at Step S704, magnetic domain information at the pixel to be compared 520 in the region to be compared 510. Then, the processing at Step S711 to be described later is performed.

On the other hand, as a result of the determination at Step S708, when the maximum value of the degrees of match between the region to be compared 510 and each of the template images 410 does not exceed the threshold value (in the case of NO at Step S708), the processing at Step S710 is performed. At Step S710, the magnetic domain information deriving part 214 sets the pixel to be compared 520 set at Step S704 as the blank pixel 520'. Then, the processing at Step S711 is performed.

At Step S711, the comparison part 213 determines whether or not all pixels in the pixel to be compared setting region 530 have been set as the pixel to be compared 520. As a result of this determination, when all of the pixels in the pixel to be compared setting region 530 have not been set as the pixel to be compared 520 (in the case of NO at Step S711), the processing at Step S704 in Fig. 7A is performed again. Then, a new pixel to be compared 520 is set at Step S704, and pieces of the processing for the new set pixel to be compared 520 are performed again. Pieces of the processing at Step S704 to S711 are performed repeatedly until it is determined that all of the pixels in the pixel to be compared setting region 530 have been set as the pixel to be compared 520 at Step S711.

Then, at Step S711, when it is determined that all of the pixels in the pixel to be compared setting region 530 have been set as the pixel to be compared 520 (in the case of YES at S711), the processing at Step S712 is performed. At Step S712, the magnetic domain information deriving part 214 determines whether or not the blank pixel 520' has been set (for at least one pixel to be compared 520) at Step S710. As a result of this determination, when the blank pixel 520' has not been set (in the case of NO at Step S712), pieces of the processing at Steps S713 to S715 are omitted, and the processing at S716 to be described later is performed.

On the other hand, at Step S712, it is checked whether or not the blank pixels 520' have been set at Step S710 described previously. As a result of this check, when it is determined that the blank pixels 520' have been set (in the case of YES at S712), the processing at Step S713 is performed. At Step S713, the supplementary magnetic domain information deriving part 215 selects one of the blank pixels 520' set at Step S710 in order.

Then, at Step S714, the supplementary magnetic domain information deriving part 215 selects at least one piece of the magnetic domain information derived at Step S709 based on the position of the blank pixel 520' selected at Step S712 and the position of the pixel to be compared 520 set at Step S704. Then, the supplementary magnetic domain information deriving part 215 calculates magnetic domain information (supplementary magnetic domain information) at the selected blank pixel 520' based on the magnetic domain information selected.

Then, at Step S715, it is determined whether or not the supplementary magnetic domain information deriving part 215 has selected all of the blank pixels 520' set at Step S710. As a result of this determination, when all of the blank pixels 520' have not been selected (in the case of NO at Step S715), the processing at Step S713 is performed again. Then, at Step S713, one new blank pixel 520' is selected. Further, at Step S714, magnetic domain information (supplementary magnetic domain information) at the new selected blank pixel 520' is calculated. Pieces of the processing at S713 to S715 are performed repeatedly until it is determined at Step S715 that all of the blank pixels 520' set at Step S710 have been selected.

Then, at Step S715, when it is determined that all of the blank pixels 520' set at Step S710 have been selected (in the case of YES at Step S715), the processing at Step S716 is performed. At Step S716, the output part 216 outputs all magnetic domain information including the magnetic domain information derived at Step S709 and the supplementary magnetic domain information derived at Step S714. Incidentally, when it is determined that the blank pixel 520' has not been set (NO) at Step S712 and then the processing at Step S716 is performed, the supplementary magnetic domain information is not included in the all magnetic domain information.

When the processing at Step S716 is finished, pieces of the processing according to the flowcharts in Fig. 7A and Fig. 7B are finished.

<Summary>

As above, in this embodiment, the processing device 200 derives the magnetic domain information at the pixel to be compared 520 in the region to be compared 510 based on the result of comparison of the region to be compared 510 in the magnetic domain image 300 with one or more of the template images 410. In each of the template images 410, magnetic domain information (values such as the magnetic domain width w and the magnetic domain angle θ) according to an image is set in advance. The processing device 200 reflects the result of comparison of the region to be compared 510 with the template image 410 in the pixel to be compared 520 within the region to be compared 500, thereby making it possible to quantify and derive the magnetic domain information (values such as the magnetic domain width w and the magnetic domain angle θ) at the pixel to be compared 520 where magnetic domain information is to be derived, by template matching. Therefore, the magnetic domain information in the region to be compared 510 can be derived with a desired resolution based on the prepared template image. Further, the magnetic domain information, which is not easily affected by noise or the like, can be derived robustly. As a result, the magnetic domain information can be derived with higher accuracy.

Further, in this embodiment, the processing device 200 sets the magnetic domain information that the template image 410, which is determined to correspond to the region to be compared 510 by the results of comparison of the region to be compared 510 with the plural template images 410 satisfying a predetermined condition, has as the magnetic domain information in the region to be compared 510. Therefore, it is possible to appropriately select the template image 410 that corresponds to the region to be compared 510 from among the plural template images 410. Therefore, it is possible to quantify and derive the magnetic domain information (such as the magnetic domain width w and the magnetic domain angle θ) at the pixel to be compared 520 where magnetic domain information is to be derived, with even higher accuracy by template matching. This makes it possible to derive the magnetic domain information with even higher accuracy.

Further, in this embodiment, the processing device 200 sets the magnetic domain information that the template image 410, which is determined to correspond to the region to be compared 510 by the result of comparison of the region to be compared 510 with the template image 410 satisfying the predetermined condition, has as the magnetic domain information in the region to be compared 510. In this case, the magnetic domain information corresponding to the region to be compared 510 that does not satisfy the aforementioned predetermined condition (the magnetic domain information at the blank pixel 520') is not derived. Therefore, it is possible to prevent inaccurate information from being derived as the magnetic domain information.

Further, in this embodiment, the processing device 200 derives the magnetic domain information in the region to be compared 510 where magnetic domain information was not derived (magnetic domain information at the blank pixels 520' (supplementary magnetic domain information)) based on the magnetic domain information in at least one other region to be compared 510 where magnetic domain information has already been derived. Therefore, it is possible to reduce the region where no magnetic domain information is derived while inhibiting the decrease in the accuracy of deriving the magnetic domain information.

Further, in this embodiment, the processing device 200 selects the magnetic domain information in the previously-described at least one other region to be compared 510 based on the position of the region to be compared 510 where magnetic domain information was not derived (the position of the blank pixel 520') and the other region to be compared 510 where magnetic domain information has already been derived (the position of the pixel to be compared 520). In the magnetic body, regions each having the same magnetic domain width w are often distributed in clusters within crystal grains. Therefore, for example, the magnetic domain information at the blank pixel 520' can be supplemented by using the magnetic domain width w at a position close to the position of the region to be compared 510 where magnetic domain information was not derived (the position of the blank pixel 520') among the positions of the pixels to be compared 520 in the other region to be compared 510 where magnetic domain information has already been derived. Therefore, the magnetic domain information at the blank pixel 520' can be estimated with high accuracy.

Further, in this embodiment, the magnetic domain widths w illustrated in at least two of the plural template images 410 are made mutually different. Therefore, by selecting the most matching template image or the like, the magnetic domain width w can be derived with higher accuracy as the magnetic domain information. Further, in this embodiment, the directions in which the magnetic domains illustrated in at least two of the plural template images extend are made mutually different. Therefore, by selecting the most matching template image or the like, the magnetic domain direction (for example, the magnetic domain angle θ) can be derived with higher accuracy as the magnetic domain information without performing processing such as rotation of images.

Further, in this embodiment, at least one of the magnetic domain image 300 and the template image 410 is rotated, and the region to be compared 510 and the template image 410 are compared. Therefore, by selecting the most matching template image or the like, the magnetic domain direction (for example, the magnetic domain angle θ) can be derived with higher accuracy as the magnetic domain information.

(Second embodiment)

Next, a second embodiment is explained. The first embodiment has explained, as an example, the case where the information on the first magnetic domain (black region) (for example, the magnetic domain width w and the magnetic domain angle θ) is determined in the template image 410 because magnetic domains that are present at positions close to each other do not differ significantly in the magnetic domain information regardless of the first magnetic domain and the second magnetic domain. In contrast to this, this embodiment explains, as an example, the case where in addition to such a template image 410, a template image, in which the information on the second magnetic domain (white region) (for example, the magnetic domain width w and the magnetic domain angle θ) is determined, and the region to be compared 510 are compared. The information on the first magnetic domain and the information on the second magnetic domain are determined, thereby making it possible to accurately derive more detailed magnetic domain information. Thus, this embodiment differs from the first embodiment mainly in that the number of template images to be compared with the region to be compared 510 is increased. Therefore, in the explanation of this embodiment, the same reference numerals and symbols as those used in Fig. 1 to Fig. 7B are added to the same parts as those in the first embodiment, and detailed explanations of the parts are omitted.

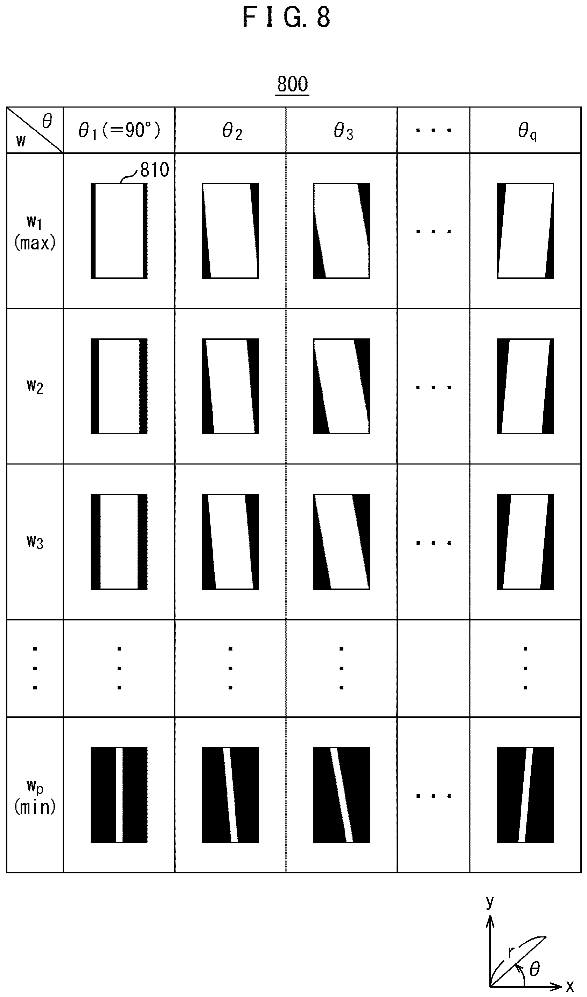

Fig. 8 is a view illustrating an example of a template image group 800 including a plurality of template images 810 each having information on the second magnetic domain determined therein. As in Fig. 4, in Fig. 8 as well, for convenience of notation, only one template image is marked with a reference numeral (810).

The template image 810 is fabricated by, for example, replacing the first magnetic domain (black region) and the second magnetic domain (white region) with each other with respect to template image 410. Further, similarly to the template image 410, the region to be compared 510 may be rotated by the angle step $\Delta\theta$ without rotating the template image 810. In this case, the rotated region to be compared 510 may be superimposed on the template image 810, to thereby make the magnetic domain direction illustrated in the template image 810 different from the magnetic domain direction illustrated in the region to be compared 510. Incidentally, the magnetic domain angles $\theta_2, \theta_3, \dots, \theta_q$ of the first magnetic domain in the template images 410 and magnetic domain angles $\theta_2, \theta_3, \dots, \theta_q$ of the second magnetic domain in the template images 810 may be the same or different. Similarly, the magnetic domain widths $w_1, w_3, \dots, w_p$ of the first magnetic domain in the template images 410 and magnetic domain widths $w_1, w_3, \dots, w_p$ of the second magnetic domain in the template images 810 may be the same or different.

In this embodiment, the template image 410 is an example of a first template image corresponding to the first magnetic domain. Further, in this embodiment, the template image 810 is an example of a second template image corresponding to the second magnetic domain. Incidentally, the boundary (magnetic domain wall) between the first magnetic domain and the second magnetic domain is not limited to a 180° magnetic domain wall as long as the magnetic moments of the first magnetic domain and the second magnetic domain are different in the orientation from each other. Further, when it is assumed that three or more magnetic domains are present in the magnetic domain image, one or more template images may be prepared for each of all or some of the three or more magnetic domains.

In a processing method (flowchart) in this embodiment, for example, the template image to be read out at Step S705 in Fig. 7 is the template image 410 illustrated in Fig. 4 and the template image 810 illustrated in Fig. 8. Further, at Step S707, it is determined whether or not all of the template images 410 illustrated in Fig. 4 and the template images 810 illustrated in Fig. 8 have been read out.

As above, in this embodiment, the processing device 200 performs comparison of the region to be compared 510 with the template images 410 and 810. Therefore, the blank pixels 520' can be reduced and the accuracy of deriving magnetic domain information can be improved.

(Third embodiment)

Next, a third embodiment is explained. This embodiment explains, as an example, the case where processing based on the magnetic domain information derived as explained in the first embodiment and the second embodiment is performed. As above, in this embodiment, configurations and processing for performing the processing based on the magnetic domain information are added to the first embodiment and the second embodiment. Therefore, in the explanation of this embodiment, the same reference numerals and symbols as those used in Fig. 1 to Fig. 8 are added to the same parts as those in the first embodiment and the second embodiment, and detailed explanations of the parts are omitted.

A processing system in this embodiment performs the processing based on the magnetic domain information in addition to deriving the magnetic domain information.

As has been explained in the first embodiment and the second embodiment, using the methods in the first embodiment and the second embodiment makes it possible to derive magnetic domain information including magnetic domain widths with high accuracy while reducing the influence of noise. Therefore, utilizing such information on magnetic domain widths makes it possible to more effectively improve, for example, the magnetic properties (for example, the iron loss) of the magnetic body S (soft magnetic material).

Thus, this embodiment explains, as an example, the case where processing for adjusting the magnetic domain width of the magnetic body S is included in the processing based on the magnetic domain information. Incidentally, the processing based on the magnetic domain information is not limited to such processing. For example, processing may be performed to derive other manufacturing conditions in addition to or instead of the magnetic domain width. For example, processing for adjusting the magnetic domain angle may be performed. Incidentally, in the following explanation, the magnetic domain operation including the magnetic domain width adjustment is referred to as magnetic domain control as necessary.

Further, the processing based on the magnetic domain information is not limited to the processing to derive manufacturing conditions of the magnetic body S. For example, processing in which each pixel of the magnetic domain image is converted into a color that corresponds to the value of the magnetic domain information corresponding to the pixel may be performed. In this case, each position in the magnetic domain image can be colored and displayed with a color that corresponds to the value of the magnetic domain information. This enables an operator to more intuitively grasp the distribution of magnetic domain information. For example, a gradation value (for example, 0 to 255) indicating one color (for example, R) out of RGB (red, green, blue) may be made to correspond to the value of the magnetic domain width w. Further, a gradation value (for example, 0 to 255) indicating another color (for example, G) out of RGB (red, green, blue) may be made to correspond to the value of the magnetic domain angle $\theta$. Further, a gradation value indicating the other color (for example, B) out of RGB (red, green, blue) may be set to a constant value.

This embodiment explains, as an example, the case where the soft magnetic material in the process of manufacturing a grain-oriented electrical steel strip is the magnetic body S, which is a target for acquiring a magnetic domain image and on which magnetic domain control is to be performed. However, the magnetic body S is not limited to such a soft magnetic material as long as it is a soft magnetic material on which magnetic domain control can be performed.

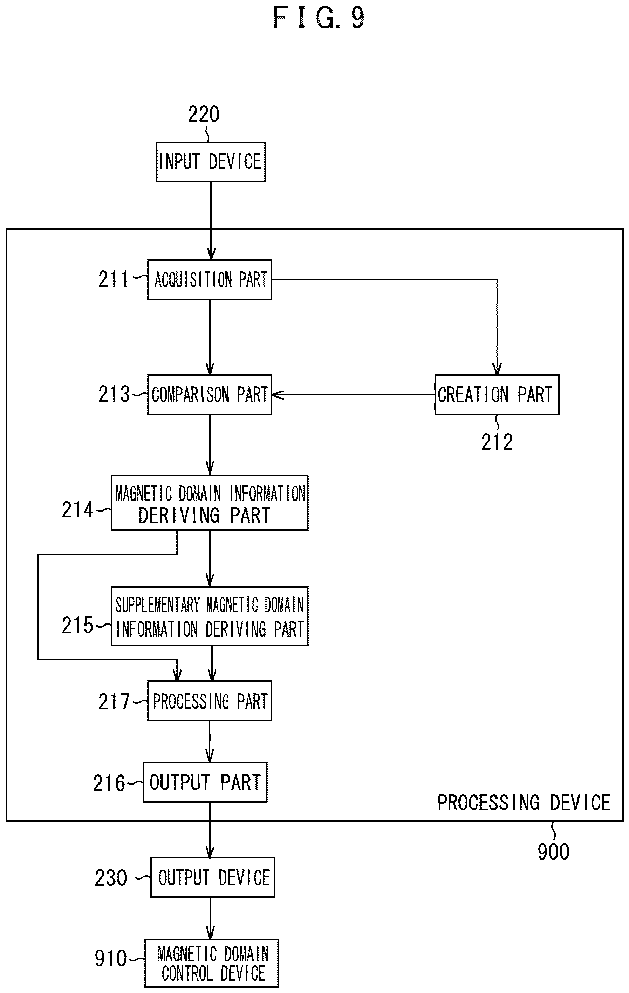

Fig. 9 is a diagram illustrating an example of a functional configuration of a processing device 900. The hardware of the processing device 900 may be the same as that of the processing device 200 explained in the first embodiment. This embodiment explains, as an example, the case where the processing system includes a magnetic domain image acquisition device 100, the processing device 900, and a magnetic domain control device 910.

<Magnetic domain image acquisition device 100>

The magnetic domain image acquisition device 100 may be the same as the magnetic domain image acquisition device 100 explained in the first embodiment. The magnetic domain image acquisition device 100 may acquire the magnetic domain image 300 of the magnetic body S that is being conveyed. In this case, the magnetic domain image acquisition device 100 may acquire the magnetic domain image 300 of the magnetic body S that is being conveyed along a manufacturing line while being unwound from a coil, for example. Further, the magnetic domain image acquisition device 100 may acquire the magnetic domain image 300 of the magnetic body S that is not being conveyed (namely, the magnetic body S that is not moving). In this case, the magnetic domain image acquisition device 100 may acquire the magnetic domain image 300 of the magnetic body S that has been cut off from a coil, for example.

<Magnetic domain control device 910>

The magnetic domain control device 910 is a device that performs the magnetic domain control on the magnetic body S (soft magnetic material). The magnetic domain control device 910 may perform the magnetic domain control on the magnetic body S that is being conveyed. In this case, the magnetic domain control device 910 may perform the magnetic domain control on the magnetic body S that is being conveyed on a manufacturing line while being unwound from a coil, for example. Further, the magnetic domain control device 910 may perform the magnetic domain control on the magnetic body S that is not being conveyed (namely, the magnetic body S that is not moving).

Further, this embodiment explains, as an example, the case where after an operation instruction for the magnetic domain control device 910 on the magnetic body S is output from the processing device 900 as will be described later, the magnetic domain control device 910 performs the magnetic domain control on the magnetic body S.

Further, this embodiment explains, as an example, the case where the magnetic domain control device 910 is a device that performs the magnetic domain control on the magnetic body S by irradiating the magnetic body S with a laser beam or an electron beam. In this case, the magnetic domain control device 910 may irradiate the magnetic body S in the width direction with a laser beam or an electron beam. Further, the magnetic domain control device 910 may irradiate the entirety of at least one of the front surface and the rear surface of the plate-shaped or strip-shaped magnetic body S with a laser beam or an electron beam. In the following explanation, there is explained, as an example, the case where the magnetic domain control device 910 includes an irradiation part that applies a laser beam. Incidentally, when the magnetic domain control device 910 applies an electron beam, the laser beam is replaced with the electron beam in the following explanation.

When the magnetic body S, which is being conveyed on the manufacturing line while being unwound from a coil, is a soft magnetic material in the process of manufacturing the grain-oriented electrical steel strip, the magnetic domain control device 910 may irradiate the magnetic body S being conveyed on the manufacturing line with a laser beam, for example, after a cold rolling step is finished and before a step of forming a coating (for example, an insulating coating) on the steel sheet surface is started. Incidentally, the manufacturing line preferably includes, for example, a hot rolling step, a cold rolling step, and a step of forming a coating on the steel sheet surface. Incidentally, the hot rolling step is a step of hot rolling a steel material such as a slab. The cold rolling step is a step of cold rolling the steel strip after the hot rolling step. The step of forming a coating on the steel sheet surface is a step of forming a coating on the surface of the steel strip after the cold rolling step. Further, the manufacturing line more preferably includes an annealing step and a pickling step in addition to these steps. The annealing step is a step of continuously annealing the steel strip after the cold rolling step. In the annealing step, strain of the steel strip is reduced (preferably removed). The pickling step is a step of pickling the steel strip after the annealing step. In the pickling step, scale formed on the surface of the steel strip is reduced (preferably removed). Incidentally, the hot rolling step, the cold rolling step, and the step of forming a coating on the steel sheet surface may be performed on separate manufacturing lines. Each of the steps from the cold rolling step to the step of forming a coating on the steel sheet surface may be performed continuously on the same manufacturing line. When the annealing step is performed, the irradiation with a laser beam is performed after the annealing step. When the pickling step is performed, the irradiation with a laser beam is preferably performed after the pickling step. The hot rolling step, the cold rolling step, the step of forming a coating on the steel sheet surface, the annealing step, and the pickling step themselves can be achieved by well-known techniques. Therefore, detailed explanations of these steps are omitted here.

Incidentally, the magnetic domain control device 910 is not limited to the device that applies a laser beam or an electron beam, as long as it is a device capable of performing the magnetic domain control on the soft magnetic material so that the magnetic domain width is varied. For example, the magnetic domain control device 910 may be a device that forms grooves in the magnetic body S by physically contacting the magnetic body S. Further, for example, the magnetic domain control device 910 may be a device that performs electric field etching on the magnetic body S.

<Processing device 900>

<<Acquisition part 211, Creation part 212, Comparison part 213, Magnetic domain information deriving part 214, Supplementary magnetic domain information deriving part 215, Output part 216>>

An acquisition part 211, a creation part 212, a comparison part 213, a magnetic domain information deriving part 214, a supplementary magnetic domain information deriving part 215, and an output part 216 have the same functions as those explained in the first embodiment and the second embodiment.

For example, the acquisition part 211 may acquire one magnetic domain image 300 from one coil, or may acquire a plurality of magnetic domain images 300 from one coil. When the acquisition part 211 acquires plural magnetic domain images 300, the creation part 212, the comparison part 213, the magnetic domain information deriving part 214, and the supplementary magnetic domain information deriving part 215 may perform pieces of the processing explained in the first embodiment and the second embodiment with each of the plural magnetic domain images 300 acquired by the acquisition part 211 set as the magnetic domain image to be processed, for example.

Further, this embodiment explains, as an example, the case where the output part 216 outputs to the output device 230 the operation instruction for the magnetic domain control device 910 in addition to or instead of the all magnetic domain information.

<<Processing part 217>>

A processing part 217 performs processing based on the magnetic domain information derived by the magnetic domain information deriving part 214. This embodiment explains, as an example, the case where the processing part 217 performs processing based on the all magnetic domain information. As has been explained in the first embodiment, in the all magnetic domain information, all pieces of the magnetic domain information derived by the magnetic domain information deriving part 214 and all pieces of the supplementary magnetic domain information derived by the supplementary magnetic domain information deriving part 215 are included. For example, when performing processing based on the magnetic domain information, the processing part 217 does not need to use some of the magnetic domain information derived by the magnetic domain information deriving part 214. Further, the processing part 217 does not need to use all or some of the supplementary magnetic domain information derived by the supplementary magnetic domain information deriving part 215, for example.

Further, this embodiment explains, as an example, the case where the processing part 217 performs processing based on the all magnetic domain information every all magnetic domain information to be derived from one magnetic domain image 300 (namely, every one magnetic domain image 300). However, this embodiment does not necessarily need to be designed in this manner. The processing part 217 may perform processing based on the all magnetic domain information every all magnetic domain information to be derived from plural magnetic domain images 300 (namely, every plural magnetic domain images 300).

Further, as described previously, this embodiment explains, as an example, the case where processing for adjusting the magnetic domain width of the magnetic body S is included in the processing to be performed by the processing part 217. However, it has been noted above that the processing based on the magnetic domain information is not limited to such processing. When the processing for adjusting the magnetic domain width of the magnetic body S is not included in the processing to be performed by the processing part 217, the processing system does not need to include the magnetic domain control device 910. Further, a processing device different from the processing device 900 may have the functions of the processing part 217. In this case, the processing device 900 and the different processing device may communicate with each other.

There is explained an example of the processing for adjusting the magnetic domain width of the magnetic body S below.

This embodiment explains, as an example, the case where the processing part 217 derives information representing the frequency distribution of magnetic domain widths. The information representing the frequency distribution of magnetic domain widths may be information indicating the relationship between the value of the magnetic domain width and the number of magnetic domain widths having the value. Further, the information representing the frequency distribution of magnetic domain widths may be information indicating the relationship between the range of the magnetic domain width and the number of magnetic domain widths having valueswithin the range. The information representing the frequency distribution of magnetic domain widths may be, for example, a histogram. Further, the information representing the frequency distribution of magnetic domain widths may be a table. Further, the information representing the frequency distribution of magnetic domain widths may be a function. In this case, the number of magnetic domain widths may be expressed as a function of the value of the magnetic domain width. The order of the function is not limited. Further, coefficients and constants of the function may be derived, for example, by using curve fitting.

Further, this embodiment explains, as an example, the case where the processing part 217 uses all magnetic domain information derived with one magnetic domain image 300 set as the magnetic domain image to be processed, to derive information representing the frequency distribution of magnetic domain widths included in the all magnetic domain information. However, the processing part 217 may use all magnetic domain information derived with a plurality of magnetic domain images 300 set as the magnetic domain image to be processed, to derive information representing the frequency distribution of magnetic domain widths included in the all magnetic domain information.

In the one magnetic domain image 300, magnetic domain widths corresponding to the number of partial regions to be compared with the template image 410 (for example, the number of regions to be compared 510 illustrated in Fig. 5) are derived. When using the all magnetic domain information derived with one magnetic domain image 300 set as the magnetic domain image to be processed to derive information representing the frequency distribution of magnetic domain widths included in the all magnetic domain information, the processing part 217 uses the magnetic domain widths corresponding to the number of partial regions to derive information representing the frequency distribution of the magnetic domain widths.

Incidentally, when supplementary magnetic domain information was not derived by the supplementary magnetic domain information deriving part 215 and when supplementary magnetic domain information is not derived, the number of magnetic domain widths to be derived from one magnetic domain image 300 becomes the number of pieces of the magnetic domain information derived by the magnetic domain information deriving part 214.

Incidentally, the processing part 217 derives the information representing the frequency distribution of the magnetic domain widths, thereby allowing a user to more intuitively grasp the distribution of the magnetic domain widths. Therefore, when not performing the processing for adjusting the magnetic domain width of the magnetic body S, the processing part 217 may derive the information representing the frequency distribution of the magnetic domain widths. Further, the processing part 217 may derive information representing the frequency distribution of magnetic domain angles instead of or in addition to the information representing the frequency distribution of the magnetic domain widths.

In order to adjust the magnetic domain width, in addition to or instead of the intensity of a laser beam, the irradiation time and the number of times of irradiation with a laser beam may be adjusted. However, in this case, a case may arise in which it is necessary to slow down the conveyance speed of the magnetic body S. Thus, this embodiment explains, as an example, the case where the processing part 217 determines the intensity of a laser beam in order to adjust the magnetic domain width.

When the intensity of a laser beam is varied, the mode value of the magnetic domain width in the magnetic body S varies. When the intensity of a laser beam is varied, the average value of the magnetic domain widths in the magnetic body S also varies. However, when regions having extremely wide magnetic domain widths or regions having extremely narrow magnetic domain widths are present in the magnetic body S, the average value of the magnetic domain widths in the magnetic body S varies. On the other hand, the iron loss of the magnetic body S is determined by the distribution of magnetic domain widths over the entire surface of the magnetic body S. Local abnormal values of the magnetic domain width have a significant impact on the average value of the magnetic domain widths. However, the area of a magnetic domain having a magnetic domain width that exhibits a local abnormal value to the entire surface of the magnetic body S is small. Therefore, it is not preferable for an indicated value of the intensity of a laser beam to be affected by the local abnormal value of the magnetic domain width. Therefore, it is preferable to manufacture the magnetic body S (soft magnetic material) based on the mode value of the magnetic domain width.

Thus, this embodiment explains, as an example, the case where the processing part 217 performs the processing for adjusting the magnetic domain width of the magnetic body S based on the mode value of the magnetic domain width in the frequency distribution of the magnetic domain widths. However, a representative value other than the mode value may be used in addition to or instead of the mode value. As the representative value other than the mode value, for example, the median value may be used.

For example, when the information representing the frequency distribution of the magnetic domain widths is a function, the value of one or more magnetic domain widths having the maximum value of the aforementioned function is the mode value of the magnetic domain width. Further, for example, when the frequency distribution of the magnetic domain widths is expressed by a histogram, one or more classes (ranges of the magnetic domain width) having the maximum frequency in the histogram are the mode value of the magnetic domain width.

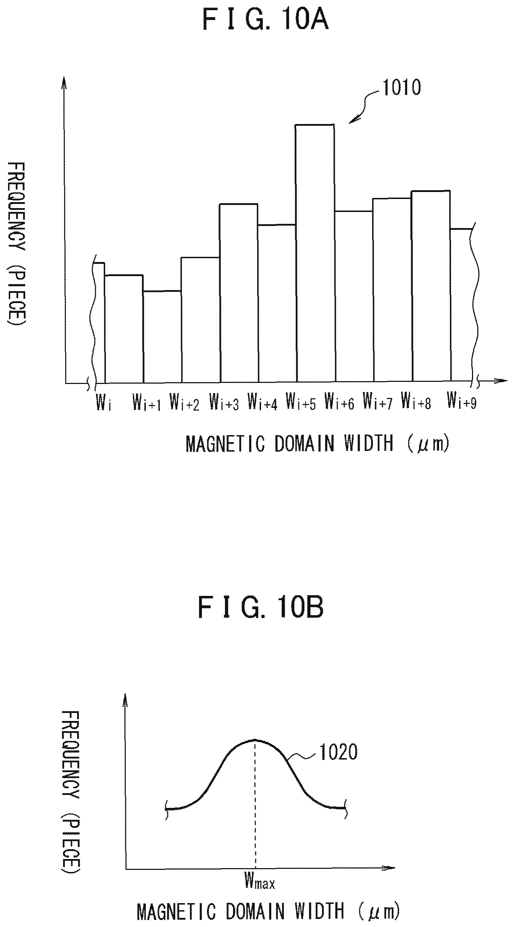

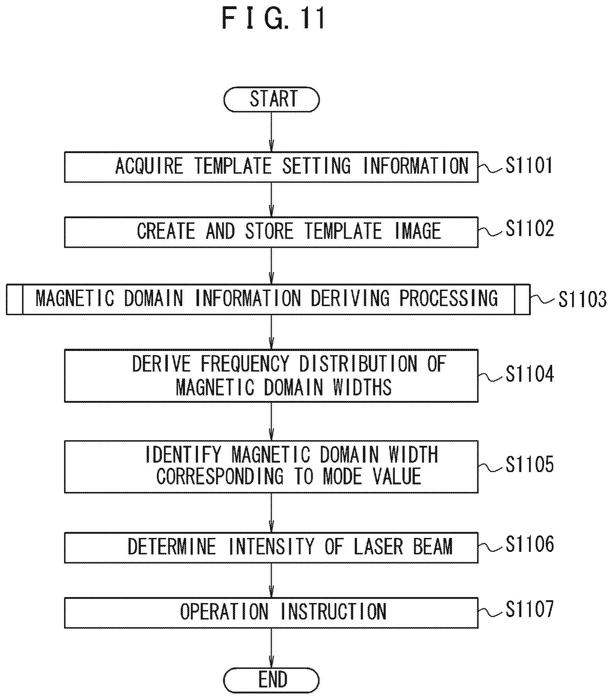

Fig. 10A is a view illustrating an example of a histogram 1010 of magnetic domain widths. In Fig. 10A, magnetic domain widths $W_i$ to $W_{i+9}$ indicate the upper limit value and the lower limit value of respective classes of the histogram 1010 of the magnetic domain widths. i in the magnetic domain widths $W_i$ to $W_{i+9}$ is an integer of 1 or more. Incidentally, in order to distinguish the reference symbols representing the magnetic domain width from the reference symbols ($w_1$ to $w_p$) illustrated in Fig. 4, as the reference symbols representing the magnetic domain widths in Fig. 10A and Fig. 10B, a capital letter W is used. In Fig. 11A, the range (class) of the magnetic domain widths $W_{i+5}$ to $W_{i+6}$ is the range of the magnetic domain width that corresponds to the mode value of the magnetic domain width in the frequency distribution of the magnetic domain widths. In this case, the processing part 217 may identify the representative value (for example, an arithmetic mean value) of the class as the mode value of the magnetic domain width.

Fig. 10B is a view illustrating an example of a function 1020 of the frequency distribution of the magnetic domain widths. Fig. 10B illustrates, as an example, the case where a magnetic domain width $W_{max}$ (one value) indicating the maximum value in the function 1020 of the frequency distribution of the magnetic domain widths is the mode value of the magnetic domain width in the frequency distribution of the magnetic domain widths. The processing part 217 identifies the magnetic domain width $W_{max}$ as the mode value of the magnetic domain width.

Incidentally, when there are a plurality of values (a plurality of classes) as the mode value of the magnetic domain width, the processing part 217 may treat each of the plural values (plural classes) as the mode value of the magnetic domain width. Further, the processing part 217 may select one or more of these plural values (plural classes). For example, the processing part 217 may treat the maximum value (class) out of these plural values (plural classes) or a value (class) exceeding a predetermined value as the mode value of the magnetic domain width.

Further, when the intensity of a laser beam is large, the effect of subdividing the magnetic domains can be fully obtained. Therefore, an abnormal eddy current loss in the magnetic body S is reduced. However, when the intensity of a laser beam is too large, a hysteresis loss in the magnetic body S may increase due to thermal strain. Therefore, it is not sometimes preferable when the intensity of a laser beam is too large. On the other hand, when the intensity of a laser is too small, there is a risk that it is not possible to fully obtain the effect of subdividing the magnetic domains. As a result, there is a risk that it is not possible to reduce the abnormal eddy current loss in the magnetic body S. In view of the above, it is preferable to control the intensity of a laser beam for subdividing the magnetic domains within an appropriate range. Further, an appropriate intensity of a laser beam varies depending on the magnetic domain width of the magnetic body S before the magnetic domain width is controlled. It is possible to reduce the iron loss of the magnetic body S by increasing the intensity of a laser beam to be applied to a region with a wide magnetic domain width and reducing the intensity of a laser beam to be applied to a region with a narrow magnetic domain width.

From such a viewpoint as described above, this embodiment explains, as an example, the case where the processing part 217 determines the intensity of a laser beam (or an electron beam) to be an intensity Ua ($mJ/mm^2$) that satisfies the following (2) expression.

[Mathematical expression 1]

$$0.85 + 0.9 \arctan \frac{W_m - 400}{300} < Ua < 0.95 + 1.0 \arctan \frac{W_m - 300}{300} \quad \text{-------- (2)}$$

Here, $W_m$ is the mode value ($\mu m$) of the magnetic domain width in the information representing the frequency distribution of the magnetic domain widths. Incidentally, $W_m$ is to be derived before a laser beam (or an electron beam) is applied. Further, the unit of an angle represented by arctan is a radian (rad). That is, the unit of ($W_m$ - 400)/300 and ($W_m$ - 300)/300 is a radian (rad).

Further, the processing part 217 preferably determines the intensity Ua of a laser beam so that the mode value of the magnetic domain width becomes 200 $\mu m$ or more and less than 400 $\mu m$ by irradiation with a laser beam in the information representing the frequency distribution of the magnetic domain widths. That is, the processing part 217 preferably determines the intensity Ua of a laser beam so that the mode value of the magnetic domain width to be derived with the magnetic body S (soft magnetic material) after being irradiated with the laser beam set as the magnetic domain image to be processed becomes 200 $\mu$m or more and less than 400 $\mu$m. This embodiment is designed in this manner, thereby making it possible to manufacture a soft magnetic material in which the mode value of the magnetic domain width in the information representing the frequency distribution of the magnetic domain widths is 200 $\mu$m or more and less than 400 $\mu$m.

The processing part 217 outputs an operation instruction, which indicates output of the laser beam with the intensity determined as described above, to the magnetic domain control device 910 via the output part 216. The magnetic domain control device 910 irradiates the magnetic body S with the laser beam with the intensity included in the operation instruction. At that time, the processing part 217 may derive operating conditions of the magnetic domain control device 910 and include them in the operation instruction so that an irradiation range of the magnetic body S with the laser beam (for example, the entirety of at least one of the front surface and the rear surface of the magnetic body S) is irradiated with the laser beam.

Further, on the magnetic body S after being subjected to the magnetic domain control as described above, strain relief annealing may be performed. In this case, the magnetic domain image acquisition device 100 may acquire a magnetic domain image 300 of the magnetic body S after being subjected to the strain relief annealing. Then, the processing device 900 may derive information representing the frequency distribution of magnetic domain widths based on the acquired magnetic domain image 300. In this case, in the information representing the frequency distribution of the magnetic domain widths, the mode value of the magnetic domain width is preferably 700 $\mu$m or more. In this case, by performing strain relief annealing on the magnetic body S that has been subjected to the magnetic domain control, the mode value of the magnetic domain width of the magnetic body S varies from 200 $\mu$m or more and less than 400 $\mu$m to 700 $\mu$m or more, for example. That is, the strain relief annealing is performed on the magnetic body S that has been subjected to the magnetic domain control, thereby bringing the state of the magnetic domains of the magnetic body S into a state close to the state before the magnetic domain control is performed.

The strain relief annealing is performed as follows, for example. First, the temperature of the magnetic body S is set to 800°C. The state where the temperature of the magnetic body S is at 800°C is kept for 240 minutes or more (the magnetic body S is kept warm at 800°C for 240 minutes or more). Incidentally, for reasons such as shortening the time required for strain relief annealing, the time to keep the magnetic body S warm may be 240 minutes. Thereafter, the magnetic body S is cooled as follows. First, the average cooling rate is set to greater than 0°C/h and 25°C/h or less until the temperature of the magnetic body S drops from 800°C to 200°C. Incidentally, for reasons such as shortening the time required for strain relief annealing, the average cooling rate may be 25°C/h. Thereafter, the magnetic body S is cooled down to 50°C at an average cooling rate of greater than 0°C/h and 100°C/h or less. Incidentally, for reasons such as shortening the time required for strain relief annealing, the average cooling rate may be 100°C/h.

This embodiment is designed in this manner, thereby making it possible to confirm that the magnetic body S (soft magnetic material) after being irradiated with the laser beam was the magnetic body S (soft magnetic material) in which the mode value of the magnetic domain width in the information representing the frequency distribution of the magnetic domain widths is 700 $\mu$m or more before the magnetic body S is irradiated with the laser beam.

Further, the soft magnetic material in which the mode value of the magnetic domain width in the information representing the frequency distribution of the magnetic domain widths is 700 $\mu$m or more may be manufactured as a soft magnetic intermediate material for manufacturing the magnetic body S. This soft magnetic intermediate material may be one obtained by performing the strain relief annealing on the soft magnetic material. The strain relief annealing may be one performed under the above-described conditions, for example. In this case, it is preferable to irradiate the soft magnetic intermediate material with a laser beam, to thereby manufacture the magnetic body S (soft magnetic material) in which the mode value of the magnetic domain width in the information representing the frequency distribution of the magnetic domain widths is 200 $\mu$m or more and less than 400 $\mu$m.

<Transformer>

Further, the magnetic body S manufactured by performing the magnetic domain control in the manner described above (the grain-oriented electrical steel strip in this embodiment) may be used to manufacture a core for transformers. Further, a transformer including the core may be manufactured. For example, a plurality of soft magnetic sheets are manufactured by cutting the magnetic body S into a shape that is approximately the same (preferably the same) as the planar shape of the core. The cutting may be performed by punching or laser processing. A stacked core is manufactured by stacking these plural soft magnetic sheets. Incidentally, the core for transformers is not limited to the stacked core. For example, a wound core may be manufactured as the core for transformers using the magnetic body S. The method of manufacturing the core for transformers itself can be achieved by well-known techniques. Therefore, a detailed explanation of the method of manufacturing the core for transformers is omitted here.

A coil is wound around the core for transformers manufactured as above with an insulating member provided therebetween. Examples of the coil include, for example, a primary coil to which voltage is applied and a secondary coil in which voltage is generated after transformation. The method of manufacturing the transformer itself can be achieved by well-known techniques. Therefore, a detailed explanation of the method of manufacturing the transformer itself is omitted here.

Incidentally, the magnetic body S does not need to be used for the core for transformers. For example, the magnetic body S may be used to manufacture a stator core (for example, a split core) of a rotary electric machine.

<Flowchart>

Next, there is explained an example of a processing method to be performed using the processing device 900 in this embodiment with reference to a flowchart in Fig. 11. The flowchart in Fig. 11 is achieved, for example, by a processor included in the processing device 900 expanding a program stored in a memory in the memory and executing it.

First, at Step S1101, the acquisition part 211 acquires the template setting information.

Then, at Step S1102, the creation part 212 creates and stores the plural template images 410 based on the template setting information acquired at Step S1101.

Incidentally, pieces of the processing at Steps S1101 and S1102 may be the same as those at Steps S701 and S702 in Fig. 7A, respectively.

Then, at Step S1103, magnetic domain information deriving processing is performed. The magnetic domain information deriving processing is pieces of the processing at Steps S703 to S715 in Fig. 7A and Fig. 7B, for example. Further, the processing explained in the second embodiment may be performed at Step S1103. Incidentally, there is explained, as an example, the case where one magnetic domain image 300 is acquired at Step S1103 (Step S703) here.

Then, at Step S1104, the processing part 217 extracts magnetic domain widths from the all magnetic domain information (the magnetic domain information derived at Step S709 and the supplementary magnetic domain information derived at Step S714). The processing part 217 derives information that represents the frequency distribution of the magnetic domain widths extracted in this manner.

Then, at Step S1105, the processing part 217 identifies the mode value of the magnetic domain width in the information representing the frequency distribution of the magnetic domain widths. For example, when the frequency distribution of the magnetic domain widths is represented by the histogram 1010, the mode value of the magnetic domain width is represented by a class (range of the magnetic domain width). In this case, the processing part 217 may identify the representative value (for example, an arithmetic mean value) of the class as the mode value of the magnetic domain width. Further, when the frequency distribution of the magnetic domain widths is represented by the function 1020, for example, the processing part 217 may identify the magnetic domain width at which the frequency distribution of the magnetic domain widths exhibits the maximum value in the function 1020 as the mode value of the magnetic domain width.

Then, at Step S1106, the processing part 217 determines the intensity of a laser beam based on the value of the magnetic domain width corresponding to the mode value of the magnetic domain width.

At this time, the processing part 217 preferably determines the intensity of a laser beam so as to satisfy (2) Expression. Further, the processing part 217 preferably determines the entirety of at least one of the front surface and the rear surface of the magnetic body S as an irradiation range with the laser beam.

Then, at Step S1107, the processing part 217 derives an operation instruction indicating irradiation with the laser beam with the intensity determined at Step S1107 and outputs it to the output part 216. The output part 216 outputs the operation instruction to the magnetic domain control device 910. Thereby, the magnetic domain control device 910 irradiates the magnetic body S with the laser beam with the intensity determined at Step S1107. The period during which the magnetic domain control device 910 irradiates the magnetic body S with the laser beam is, for example, the period during which the magnetic body S on which magnetic domain control is to be performed is present within the irradiation range of the laser beam applied from the magnetic domain control device 910. The magnetic body S on which magnetic domain control is to be performed may be the magnetic body S being a target for acquiring the magnetic domain image 300. Further, the magnetic body S on which magnetic domain control is to be performed may also be a base material of the magnetic body S being a target for acquiring the magnetic domain image 300. For example, when the magnetic body S being a target for acquiring the magnetic domain image 300 is one cut from a coil, the base material is the coil.

(Calculation example)

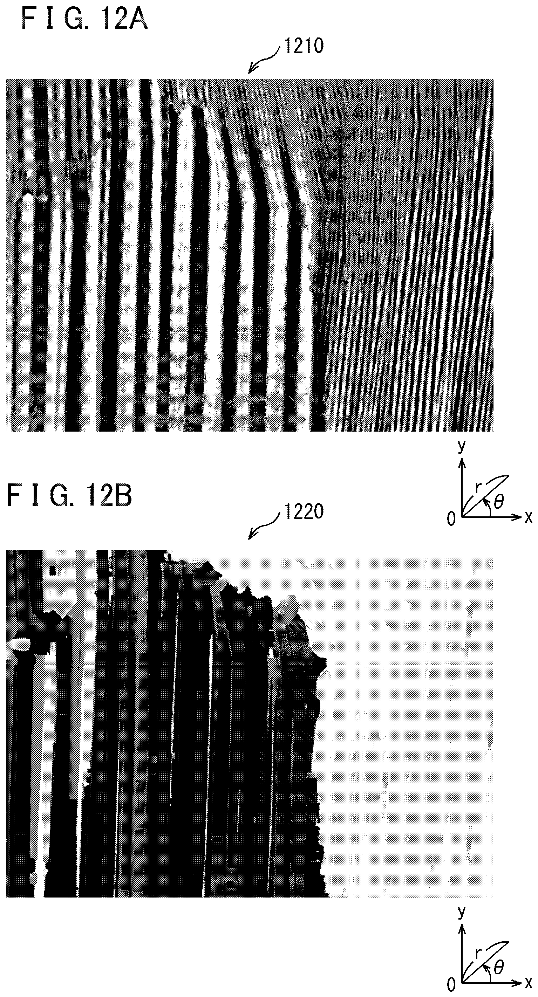

Next, a calculation example is explained. Incidentally, this calculation example is not limited to this calculation example. Fig. 12A and Fig. 12B are views each illustrating results of this calculation example. In this calculation example, a magnetic domain width w of a magnetic domain image 1210 illustrated in Fig. 12A was calculated using the method in the first embodiment. Fig. 12B illustrates the calculation result of the magnetic domain width w. The pixel of a width visualization image 1220 illustrated in Fig. 12B is the pixel to be compared 520. The position of the pixel in the width visualization image 920 corresponds to the position of the pixel in the magnetic domain image 1210 illustrated in Fig. 12A. For example, the pixel value of the pixel in the first row and first column of the width visualization image 1220 indicates the magnetic domain width w at the pixel in the first row and first column of the magnetic domain image 1210. Further, in the width visualization image 1220 illustrated in Fig. 12B, a higher density indicates a wider magnetic domain width w (in other words, a lower density indicates a narrower magnetic domain width w).

As is clear from the comparison between Fig. 12A and Fig. 12B, of the region of the width visualization image 1220 illustrated in Fig. 12B, the region corresponding to the region with a narrow width w in the magnetic domain image 1210 illustrated in Fig. 12A (for example, the region on the positive direction side of the x-axis) has a low density. Further, of the region of the width visualization image 1220 illustrated in Fig. 12B, the region corresponding to the region with a wide width w in the magnetic domain image 1210 illustrated in Fig. 12A (for example, the region near the center on the x-axis) has a high density. Thus, it can be seen that the magnetic domain information on the magnetic body S can be derived with high accuracy by the methods in the previously-described embodiments.

(Example)

Next, examples are explained. Incidentally, the present disclosure is not limited to this example. In this example, a plurality of 55 mm square samples were fabricated from a single coil of a grain-oriented electrical steel strip manufactured without performing the step of performing magnetic domain control. By taking plural samples from different locations of a single coil, plural samples with different magnetic domain structures were obtained. In this example, all of the samples were made the same in shape and size so as to satisfy the conditions specified in JIS C 2556: 2015.

Further, in the explanation of this example, the magnetic domain image was acquired as explained in the first embodiment. The magnetic domain image was acquired by photographing the entire surface (one surface) of the sample. Further, when photographing the magnetic domain image, the magnetic flux density in the sample was made to decay according to (1) Equation. Then, the magnetic domain image was acquired (photographed) at a timing at which 30 seconds had elapsed since the start of the decay.

Further, in the explanation of this example, the histogram of magnetic domain widths, which is an example of the information representing the frequency distribution of magnetic domain widths, is a histogram derived as explained in the third embodiment. The range of each class in the histogram of the magnetic domain widths was set to 50 $\mu$m. In the histogram of the magnetic domain widths, the arithmetic mean value of the class with the maximum frequency was set as the mode value of the magnetic domain width.

Further, in this example, strain relief annealing was performed on each of the samples under the same conditions. Specifically, the sample was kept at 800°C for 240 minutes or more and then cooled. At this time, the average cooling rate was set to 25°C/h or less until the temperature of the sample dropped from 800°C to 200°C. Further, the average cooling rate was set to 100°C/h or less until the temperature of the sample reached 50°C.

Further, in this example, in accordance with JIS C 2556: 2015, 55 mm square samples were used by the SST (Single Sheet Tester) method, and the iron loss of each of the samples was derived under the same conditions.

The plural samples described previously were divided into two groups: samples to be subjected to magnetic domain control by a laser beam with the same intensity; and samples to be subjected to magnetic domain control by a laser beam with the intensity derived based on (2) Expression as explained in the third embodiment. In the following explanation of this embodiment, the former sample is referred to as a comparative example sample. Further, the latter sample is referred to as an invention example sample.

Before a laser beam was applied, the iron loss of the comparative example sample was measured. Then, the magnetic domain control was performed by irradiating the entirety of the surface of the comparative example sample with a laser beam with the intensity Ua of 1.5 mJ/mm$^2$.

Then, a histogram of magnetic domain widths of the comparative example sample on which the magnetic domain control had been performed was derived.

Then, the mode value of the magnetic domain width was identified from the histogram of the magnetic domain widths of the comparative example sample on which the magnetic domain control had been performed.

Then, strain relief annealing was performed on the comparative example sample on which the magnetic domain control had been performed.

Then, a histogram of magnetic domain widths of the comparative example sample on which the strain relief annealing had been performed was derived.

Then, the mode value of the magnetic domain width was identified from the histogram of the magnetic domain widths of the comparative example sample on which the strain relief annealing had been performed.

The above was performed for each one of the comparative example samples individually. Table 1 illustrates the results of the eight comparative example samples.

[Table 1]

| No. | MODE VALUE AFTER ANNEALING [$\mu$m] | INTENSITY OF LASER BEAM [mJ/mm$^2$] | IRON LOSS RATIO | MODE VALUE DURING MAGNETIC DOMAIN CONTROL [$\mu$m] |
|---|---|---|---|---|
| 1 | 500 | 1.5 | 0.90 | 300 |
| 2 | 600 | 1.5 | 0.87 | 400 |
| 3 | 700 | 1.5 | 0.85 | 450 |
| 4 | 800 | 1.5 | 0.84 | 500 |
| 5 | 900 | 1.5 | 0.83 | 500 |
| 6 | 1000 | 1.5 | 0.80 | 550 |
| 7 | 1100 | 1.5 | 0.78 | 600 |
| 8 | 1200 | 1.5 | 0.77 | 600 |

In Table 1, "MODE VALUE AFTER ANNEALING" is the mode value of the magnetic domain width of the comparative example sample on which strain relief annealing was performed. "IRON LOSS RATIO" is the value obtained by dividing the iron loss of the comparative example sample on which magnetic domain control was performed by the iron loss of the comparative example sample before being irradiated with a laser beam. "MODE VALUE DURING MAGNETIC DOMAIN CONTROL" is the mode value of the magnetic domain width of the comparative example sample on which magnetic domain control was performed.

The iron loss of the invention example sample was also measured before a laser beam was applied. Further, a histogram of magnetic domain widths of the invention example sample was derived as explained in the third embodiment.

Then, the mode value ($\mu$m) of the magnetic domain width was identified from the histogram of the magnetic domain widths of the invention example sample before being irradiated with a laser beam, and the mode value was used as $W_m$ in (2) Expression.

Then, magnetic domain control was performed by irradiating the entirety of the surface of the invention example sample with a laser beam with the intensity Ua that satisfies (2) Expression.

Then, the iron loss of the invention example sample on which the magnetic domain control had been performed was derived. Further, a histogram of magnetic domain widths of the invention example sample on which the magnetic domain control had been performed was derived.

Next, the mode value of the magnetic domain width was identified from the histogram of the magnetic domain widths of the invention example sample on which the magnetic domain control had been performed.

Then, strain relief annealing was performed on the invention example sample on which the magnetic domain control had been performed.

Then, a histogram of magnetic domain widths of the invention example sample on which the strain relief annealing had been performed was derived.

Then, the mode value of the magnetic domain width was identified from the histogram of the magnetic domain widths of the invention example sample on which the strain relief annealing had been performed.

The above was performed for each one of the invention example samples individually. Table 2 illustrates the results of the eight invention example samples.

[Table 2]

| No. | MODE VALUE AFTER ANNEALING [$\mu$m] | INTENSITY OF LASER BEAM [mJ/mm$^2$] | IRON LOSS RATIO | MODE VALUE DURING MAGNETIC DOMAIN CONTROL [$\mu$m] |
|---|---|---|---|---|
| 1 | 500 | 1.2 | 0.90 | 350 |
| 2 | 600 | 1.5 | 0.87 | 400 |
| 3 | 700 | 1.6 | 0.84 | 350 |
| 4 | 800 | 1.7 | 0.81 | 350 |
| 5 | 900 | 1.8 | 0.78 | 300 |
| 6 | 1000 | 1.9 | 0.75 | 250 |

(continued)

| No. | MODE VALUE AFTER ANNEALING [$\mu$m] | INTENSITY OF LASER BEAM [mJ/mm$^2$] | IRON LOSS RATIO | MODE VALUE DURING MAGNETIC DOMAIN CONTROL [$\mu$m] |
|---|---|---|---|---|
| 7 | 1100 | 2.0 | 0.71 | 200 |
| 8 | 1200 | 2.1 | 0.68 | 200 |

In Table 2, "MODE VALUE AFTER ANNEALING" is the mode value of the magnetic domain width of the invention example sample on which strain relief annealing was performed. As has been explained in the third embodiment, in Table 1 and Table 2, "MODE VALUE AFTER ANNEALING" corresponds to the mode value of the magnetic domain width before magnetic domain control is performed. "IRON LOSS RATIO" is the value obtained by dividing the iron loss of the invention example sample on which magnetic domain control was performed by the iron loss of the invention example sample before being irradiated with a laser beam. "MODE VALUE DURING MAGNETIC DOMAIN CONTROL" is the mode value of the magnetic domain width of the invention example sample on which magnetic domain control was performed.

As illustrated in Table 1, when the intensity Ua of the laser beam was kept constant regardless of the magnetic domain structure, in the case where the mode value of the magnetic domain width before the magnetic domain control was performed was 700 $\mu$m or more, it was not possible to make the mode value of the magnetic domain width after the magnetic domain control (irradiation with the laser beam) was performed fall within a range of 200 $\mu$m or more and less than 400 $\mu$m (see "MODE VALUE DURING MAGNETIC DOMAIN CONTROL" in No. 3 to No. 8 in Table 1).

On the other hand, as illustrated in Table 2, when the irradiation with the laser beam with the intensity Ua satisfying (2) Expression was performed, even in the case where the mode value of the magnetic domain width before the magnetic domain control was performed was 700 $\mu$m or more, it was possible to make the mode value of the magnetic domain width after the magnetic domain control (irradiation with the laser beam) was performed fall within a range of 200 $\mu$m or more and less than 400 $\mu$m (see "MODE VALUE DURING MAGNETIC DOMAIN CONTROL" in No. 3 to No. 8 in Table 2). As a result, when the irradiation with the laser beam with the intensity Ua satisfying (2) Expression was performed, the iron loss was able to be reduced as compared to the case where the intensity Ua of the laser beam was kept constant regardless of the magnetic domain structure (see "IRON LOSS RATIO" in No. 3 to No. 8 in Tables 1 and 2).

(Other embodiments)

Incidentally, the embodiments of the present disclosure explained above can be implemented by causing a computer to execute a program. Further, a computer-readable recording medium in which the aforementioned program is recorded and a computer program product such as the aforementioned program can also be applied as the embodiment of the present disclosure. As the recording medium, it is possible to use a flexible disk, a hard disk, an optical disk, a magneto-optic disk, a CD-ROM, a magnetic tape, a nonvolatile memory card, a ROM, or the like, for example.

Further, the embodiments of the present disclosure explained above merely illustrate concrete examples of implementing the present invention, and the technical scope of the present invention is not to be construed in a restrictive manner by the embodiment. That is, the present invention may be implemented in various forms without departing from the technical spirit or main features thereof.

INDUSTRIAL APPLICABILITY

The present disclosure can be utilized for obtaining magnetic domain information, for example.

**Claims**

1.  A processing system that derives magnetic domain information on a magnetic domain image to be processed, the processing system comprising:

    a comparison part that compares a region to be compared in the magnetic domain image to be processed with one or more template images being an image having the magnetic domain information; and
    a magnetic domain information deriving part that derives the magnetic domain information in the region to be compared based on a result of the comparison, wherein
    there are a plurality of the template images that are able to be compared with the region to be compared by the comparison part, and

## EP 4 675 299 A1

a plurality of the template images have pieces of the magnetic domain information that are different mutually.

2. The processing system according to claim 1, wherein
the magnetic domain information deriving part selects a template image that satisfies a predetermined condition from the one or more template images as a template image corresponding to the region to be compared, and sets magnetic domain information that the template image corresponding to the region to be compared has as magnetic domain information in the region to be compared.

3. The processing system according to claim 2, wherein
the predetermined condition is a condition that uses a degree of match between the region to be compared and the template image.

4. The processing system according to any one of claims 1 to 3, wherein
the magnetic domain image includes a plurality of the regions to be compared that become a target where the magnetic domain information is to be derived, the processing system further comprising:
a supplementary magnetic domain information deriving part that derives the magnetic domain information in the region to be compared where the magnetic domain information was not derived by the magnetic domain information deriving part, based on the magnetic domain information in at least one other region to be compared derived by the magnetic domain information deriving part.

5. The processing system according to claim 4,
wherein the supplementary magnetic domain information deriving part selects the at least one other region to be compared based on a position of the region to be compared where the magnetic domain information was not derived by the magnetic domain information deriving part and a position of the region to be compared where the magnetic domain information has been derived by the magnetic domain information deriving part.

6. The processing system according to any one of claims 1 to 5, wherein

in the magnetic domain image, images of a first magnetic domain and a second magnetic domain whose orientations of magnetic moments are different mutually are included,
the template image includes a first template image corresponding to the first magnetic domain and
a second template image corresponding to the second magnetic domain, and
the comparison part compares a region to be compared of the magnetic domain image with the first template image and compares a region to be compared of the magnetic domain image with the second template image.

7. The processing system according to any one of claims 1 to 6, wherein
the magnetic domain information includes information indicating at least one of a magnetic domain width and a direction in which a magnetic domain extends.

8. The processing system according to claim 7, wherein
in at least two template images of a plurality of the template images, at least one of magnetic domain widths and directions in which a magnetic domain extends is different mutually.

9. The processing system according to any one of claims 1 to 8, wherein
the comparison part compares the region to be compared with the template image after rotating at least one of the magnetic domain image and the template image.

10. The processing system according to any one of claims 1 to 9, further comprising:
a processing part that performs processing based on magnetic domain information derived by the magnetic domain information deriving part.

11. The processing system according to claim 10, wherein

the magnetic domain information includes magnetic domain widths, and
regarding the magnetic domain widths derived with one of the magnetic domain images or a plurality of the magnetic domain images set as the magnetic domain image to be processed, the processing part derives information representing a frequency distribution of the magnetic domain widths.

28

**12.** The processing system according to claim 11, wherein
the processing part performs processing for adjusting the magnetic domain width of a soft magnetic material based on the information representing the frequency distribution of the magnetic domain widths.

**13.** The processing system according to claim 12, wherein
the processing part performs processing for adjusting the magnetic domain width of the soft magnetic material based on a representative value of the magnetic domain widths in the information representing the frequency distribution of the magnetic domain widths.

**14.** The processing system according to claim 13, wherein

adjustment of the magnetic domain width is performed by irradiating the soft magnetic material with a laser beam or an electron beam, and
regarding the magnetic domain widths derived with one of the magnetic domain images or a plurality of the magnetic domain images in the soft magnetic material before being irradiated with a laser beam or an electron beam set as the magnetic domain image to be processed, the processing part performs deriving information representing a frequency distribution of the magnetic domain widths, and performs determining an intensity of a laser beam or an electron beam to be applied to the soft magnetic material based on a representative value of the magnetic domain widths in the information representing the frequency distribution of the magnetic domain widths.

**15.** The processing system according to claim 14, further comprising:

an irradiation part that irradiates a soft magnetic material with a laser beam or an electron beam, wherein
the irradiation part applies a laser beam or an electron beam based on a result of processing performed by the processing part.

**16.** The processing system according to any one of claims 13 to 15, wherein
the representative value is a mode value.

**17.** The processing system according to claim 16, wherein
the processing part determines an intensity of a laser beam or an electron beam to an intensity Ua (mJ/mm$^2$) that satisfies (A) Expression below, where a mode value of the magnetic domain width in the information representing the frequency distribution of the magnetic domain widths is set to $W_m$ ($\mu$m) and a unit of an angle expressed by arctan is set to rad.
[Mathematical expression 1]

$$0.85+0.9\arctan\left(\frac{W_m-400}{300}\right) < Ua < 0.95+1.0\arctan\left(\frac{W_m-300}{300}\right) \quad \text{------ (A)}$$

**18.** The processing system according to claim 16 or 17, wherein
the processing part determines the intensity of the laser beam or the electron beam so that the mode value of the magnetic domain width of the soft magnetic material after being irradiated with the laser beam or the electron beam is 200 $\mu$m or more and 400 $\mu$m or less in the information representing the frequency distribution of the magnetic domain widths.

**19.** The processing system according to any one of claims 16 to 18, wherein
in the information representing the frequency distribution of the magnetic domain widths, the mode value of the magnetic domain width of the soft magnetic material before being irradiated with the laser beam or the electron beam is 700 $\mu$m or more.

**20.** The processing system according to any one of claims 16 to 19, wherein

regarding the magnetic domain widths derived with one of the magnetic domain images or a plurality of the magnetic domain images in the soft magnetic material that has been irradiated with the laser beam or the electron beam and then has been subjected to strain relief annealing set as the magnetic domain image to be processed, the processing part derives information representing a frequency distribution of the magnetic domain widths, and in the information representing the frequency distribution of the magnetic domain widths, the mode value of the magnetic domain width is 700 μm or more.

21. A soft magnetic material, wherein in information representing a frequency distribution of the magnetic domain widths derived by the processing part included in the processing system according to any one of claims 16 to 20, a mode value of the magnetic domain width is 200 μm or more and less than 400 μm.

22. The soft magnetic material according to claim 21, wherein

   when strain relief annealing is performed on the soft magnetic material, the mode value of the magnetic domain width in the information representing the frequency distribution of the magnetic domain widths derived by the processing part is 700 μm or more, and
   the strain relief annealing is performed by keeping the soft magnetic material warm at 800°C for 240 minutes, cooling the soft magnetic material at an average cooling rate of 25°C/h until the temperature of the soft magnetic material drops from 800°C to 200°C, and then cooling the soft magnetic material at an average cooling rate of 100°C/h until the temperature of the soft magnetic material drops from 200°C to 50°C.

23. A soft magnetic intermediate material for manufacturing the soft magnetic material according to claim 21 or 22, wherein
   in information representing a frequency distribution of the magnetic domain widths being the magnetic domain widths derived by the processing part included in the processing system according to claim 19 or 20, a mode value of the magnetic domain width is 700 μm or more.

24. A transformer comprising a core including the soft magnetic material according to claim 21 or 22.

25. A processing method of deriving magnetic domain information on a magnetic domain image to be processed, the method comprising:

   a comparison step of comparing a region to be compared in the magnetic domain image to be processed with one or more template images being an image having the magnetic domain information; and
   a magnetic domain information deriving step of deriving the magnetic domain information in the region to be compared based on a result of the comparison, wherein
   there are a plurality of the template images that are able to be compared with the region to be compared in the comparison step, and
   a plurality of the template images have pieces of the magnetic domain information that are different mutually.

26. A program for causing a computer to function as each part of the processing system according to any one of claims 1 to 20.

# F I G. 1

# F I G. 2A

```
                    220
                     ⌇
              ┌──────────────┐
              │ INPUT DEVICE │
              └──────────────┘
                     │
                     ▼
┌────────────────────────────────────────────────────────────────┐
│                                                                  │
│            ┌──────────────────┐                                  │
│  211⌇──────│ ACQUISITION PART │──────────────────┐              │
│            └──────────────────┘                   │              │
│                     │                             │              │
│                     ▼                             ▼              │
│            ┌──────────────────┐      ┌──────────────────┐       │
│  213⌇──────│ COMPARISON PART  │◄─────│  CREATION PART   │       │
│            └──────────────────┘      └──────────────────┘       │
│                     │                          ⌇                │
│                     ▼                         212               │
│            ┌──────────────────┐                                 │
│            │ MAGNETIC DOMAIN  │                                 │
│            │ INFORMATION      │                                 │
│            │ DERIVING         │                                 │
│  214⌇──────│ PART             │                                 │
│            └──────────────────┘                                 │
│                │    │                                           │
│                │    ▼                                           │
│                │  ┌──────────────────────┐                      │
│                │  │ SUPPLEMENTARY MAGNETIC│                     │
│                │  │ DOMAIN INFORMATION    │                     │
│  215⌇──────────│  │ DERIVING PART         │                     │
│                │  └──────────────────────┘                      │
│                │         │                                      │
│                ▼         ▼                                      │
│            ┌──────────────────┐                                 │
│  216⌇──────│  OUTPUT PART     │                                 │
│            └──────────────────┘                                 │
│                     │                                           │
│                     │              PROCESSING DEVICE            │
└─────────────────────┼───────────────────────────────────────────┘
                      │                              ⌇
                      ▼                             200
              ┌──────────────┐
  230⌇────────│ OUTPUT DEVICE│
              └──────────────┘
```

# F I G. 2B

EP 4 675 299 A1

# F I G. 3

# F I G. 4

<u>400</u>

# F I G. 5

# F I G. 6

# FIG. 7A

```
                    ┌─────────┐
                    │  START  │
                    └────┬────┘
                         │
                         ▼
    ┌──────────────────────────────────────────┐
    │ ACQUIRE TEMPLATE SETTING INFORMATIO │──S701
    └──────────────────┬───────────────────────┘
                       │
                       ▼
    ┌──────────────────────────────────────────┐
    │   CREATE AND STORE TEMPLATE IMAGE    │──S702
    └──────────────────┬───────────────────────┘
                       │
                       ▼
  ┌──────────────────────────────────────────────────────┐
  │ ACQUIRE MAGNETIC DOMAIN IMAGE AND THRESHOLD VALUE INFORMATION │──S703
  └──────────────────────┬───────────────────────────────┘
                         │                          ┌───┐
                         │◄─────────────────────────│ 2 │
                         │                          └───┘
                         ▼
            ┌──────────────────────────┐
            │ SET PIXEL TO BE COMPARED │──S704
            └────────────┬─────────────┘
                         │
                         ▼
    ┌──────────────────────────────────────────┐
    │      READ OUT TEMPLATE IMAGE         │──S705
    └──────────────────┬───────────────────────┘
                       │
                       ▼
         ┌──────────────────────────────┐
         │ CALCULATE DEGREE OF MATCH │──S706
         └────────────┬─────────────────┘
                      │
                      ▼
                 ╱────────────╲  ──S707
                ╱  WHETHER OR  ╲
          ╱ NOT ALL TEMPLATE IMAGES ╲   NO
         ╱    HAVE BEEN READ          ╲──────┐
          ╲        OUT?              ╱       │
                ╲            ╱               │
                 ╲──────────╱                │
                      │YES                   │
                      ▼                      │
                    ┌───┐                    │
                    │ 1 │                    │
                    └───┘                    │
```

# F I G. 7B

①

S708

MAXIMUM DEGREE
OF MATCH > THRESHOLD
VALUE?

NO

YES

DERIVE MAGNETIC DOMAIN
INFORMATION BASED ON TEMPLATE
IMAGE HAVING MAXIMUM DEGREE OF MATCH

S709

SET PIXEL TO BE COMPARED
AS BLANK PIXEL

S710

S711

WHETHER OR NOT
ALL PIXELS TO BE COMPARED
HAVE BEEN SET?

NO

②

YES

S712

WHETHER OR NOT BLANK
PIXEL HAS BEEN SET?

NO

YES

SELECT BLANK PIXEL

S713

S714

DERIVE SUPPLEMENTARY MAGNETIC DOMAIN INFORMATION

S715

WHETHER OR NOT ALL
BLANK PIXELS HAVE BEEN
SELECTED?

NO

YES

OUTPUT ALL MAGNETIC DOMAIN INFORMATION

S716

END

# F I G. 8

<u>800</u>

# F I G. 9

```
                              220
                               ⌇
                    ┌──────────────────────┐
                    │     INPUT DEVICE     │
                    └──────────────────────┘
                               │
    ┌──────────────────────────┼──────────────────────────────────────┐
    │                          ▼                                       │
    │  211⌇  ┌──────────────────────────┐                             │
    │        │     ACQUISITION PART     │─────────────────┐           │
    │        └──────────────────────────┘                 │           │
    │                          │                          │           │
    │                          ▼                          ▼           │
    │  213⌇  ┌──────────────────────┐       ┌──────────────────────┐ │
    │        │    COMPARISON PART    │◄──────│    CREATION PART     │ │
    │        └──────────────────────┘       └──────────────────────┘ │
    │                          │                        ⌇             │
    │                          ▼                       212            │
    │        ┌──────────────────────────────┐                        │
    │  214⌇  │  MAGNETIC DOMAIN INFORMATION │                        │
    │        │       DERIVING PART          │                        │
    │        └──────────────────────────────┘                        │
    │           │              │                                     │
    │           │              ▼                                     │
    │           │  ┌──────────────────────────────┐                 │
    │  215⌇     │  │ SUPPLEMENTARY MAGNETIC DOMAIN │                 │
    │           │  │  INFORMATION DERIVING PART    │                 │
    │           │  └──────────────────────────────┘                 │
    │           │              │                                     │
    │           ▼              ▼                                     │
    │  217⌇  ┌──────────────────────┐                               │
    │        │    PROCESSING PART    │                               │
    │        └──────────────────────┘                               │
    │                          │                                     │
    │                          ▼                                     │
    │  216⌇  ┌──────────────────────┐                               │
    │        │     OUTPUT PART      │           PROCESSING DEVICE    │
    │        └──────────────────────┘                               │
    └──────────────────────────┼──────────────────────────────────────┘
                               │                               ⌇
                               ▼                              900
                    ┌──────────────────────┐
    230 ⌇           │     OUTPUT DEVICE    │
                    └──────────────────────┘
                               │
                               ▼
                    ┌──────────────────────┐
    910⌇            │   MAGNETIC DOMAIN    │
                    │   CONTROL DEVICE     │
                    └──────────────────────┘
```

# FIG. 10A

# FIG. 10B

# F I G. 11

```
              ( START )
                  │
                  ▼
ACQUIRE TEMPLATE SETTING INFORMATION  ∿S1101
                  │
                  ▼
   CREATE AND STORE TEMPLATE IMAGE     ∿S1102
                  │
                  ▼
MAGNETIC DOMAIN INFORMATION DERIVING PROCESSING  ∿S1103
                  │
                  ▼
      DERIVE FREQUENCY DISTRIBUTION OF  ∿S1104
         MAGNETIC DOMAIN WIDTHS
                  │
                  ▼
     IDENTIFY MAGNETIC DOMAIN WIDTH     ∿S1105
       CORRESPONDING TO MODE VALUE
                  │
                  ▼
   DETERMINE INTENSITY OF LASER BEAM    ∿S1106
                  │
                  ▼
        OPERATION INSTRUCTION           ∿S1107
                  │
                  ▼
              ( END )
```

F I G. 12A

1210

F I G. 12B

1220

## INTERNATIONAL SEARCH REPORT

| International application No. |
|---|
| **PCT/JP2024/007577** |

| A. | CLASSIFICATION OF SUBJECT MATTER |
|---|---|

*G01R 33/12*(2006.01)i; *G01N 27/72*(2006.01)i; *G01R 33/032*(2006.01)i
FI:  G01R33/12 Z; G01N27/72; G01R33/032

According to International Patent Classification (IPC) or to both national classification and IPC

| B. | FIELDS SEARCHED |
|---|---|

Minimum documentation searched (classification system followed by classification symbols)

G01R33/12; G01N27/72; G01R33/032

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2021-169979 A (NIPPON STEEL CORP.) 28 October 2021 (2021-10-28) entire text, all drawings | 1-26 |
| A | JP 2020-169373 A (NIPPON STEEL CORP.) 15 October 2020 (2020-10-15) entire text, all drawings | 1-26 |
| A | JP 2008-224484 A (CASIO COMPUTER CO., LTD.) 25 September 2008 (2008-09-25) paragraph [0061] | 1-26 |
| A | JP 2010-203938 A (OMRON CORPORATION) 16 September 2010 (2010-09-16) paragraphs [0076], [0077] | 1-26 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **27 March 2024** | **09 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/007577**

| Patent document cited in search report | | | Publication date (day/month/year) | Patent family member(s) | Publication date (day/month/year) |
|---|---|---|---|---|---|
| JP | 2021-169979 | A | 28 October 2021 | (Family: none) | |
| JP | 2020-169373 | A | 15 October 2020 | (Family: none) | |
| JP | 2008-224484 | A | 25 September 2008 | (Family: none) | |
| JP | 2010-203938 | A | 16 September 2010 | (Family: none) | |

Form PCT/ISA/210 (patent family annex) (July 2022)

**REFERENCES CITED IN THE DESCRIPTION**

**Patent documents cited in the description**

- JP 2023032148 A

- JP 2021169979 A